# FASCICULE DE BREVET EUROPEEN

(11) **EP 2 591 508 B1**
(45) Date de publication et mention de la délivrance du brevet: **10.12.2014**
(21) Numéro de dépôt: 11741641.2
(22) Date de dépôt: 07.07.2011
(51) Int. Cl.: H02S 20/23, F24J 2/52, H01L 31/042

(54) **DISPOSITIF DE SUPPORT ET DE FIXATION DE PANNEAUX OU ANALOGUES ET SYSTEME DE TOITURE COMPORTANT UN TEL DISPOSITIF**
VORRICHTUNG ALS STÜTZE UND ZUR BEFESTIGUNG VON PLATTEN ODER DERGLEICHEN UND DACHSYSTEM MIT EINER DERARTIGEN VORRICHTUNG
DEVICE FOR SUPPORTING AND ATTACHING PANELS OR THE LIKE, AND ROOF SYSTEM COMPRISING SUCH A DEVICE

(30) Priorité: 09.07.2010 FR 1055631
(43) Date de publication de la demande: 15.05.2013
(73) Titulaire: SOPREMA (SAS), 67100 Strasbourg (FR)
(72) Inventeur: BINDSCHEDLER, Pierre Etienne, F-67210 Obernai (FR); FULCRAND, Damien, 67380 Lingolsheim (FR); PERRIN, Rémi, 67530 Boersch (FR); DESGOUILLES, Henri, F-75011 Paris (FR)
(74) Mandataire: Nuss, Laurent
(86) Numéro de dépôt international: PCT/FR2011/051626
(87) Numéro de publication internationale: WO 2012/004542

(56) Documents cités:
- DE-A1-102007 019 596
- DE-U1-202009 002 040
- DE-U1-202009 005 202
- US-A- 4 674 244
- US-A1- 2006 174 931
- US-A1- 2009 320 898

## Description

La présente invention concerne le domaine des toitures des bâtiments ou des couvertures des constructions, plus particulièrement les couvertures étanches intégrant un ou des revêtements d'étanchéité formé(s) de membranes ou de feuilles souples et partiellement déformables et a pour objet un dispositif de support et de fixation d'éléments en forme de plaques, panneaux ou analogues sur de telles couvertures de toits.

L'invention concerne plus spécifiquement la fixation de panneaux photovoltaïques.

De nombreux systèmes de montage d'éléments en plaques, panneaux ou analogues sur des couvertures de toits ont déjà été proposés.

Ces systèmes connus mettent généralement en oeuvre des éléments monoblocs en matériaux polymères ou des assemblages d'éléments métalliques permettant de supporter les plaques ou panneaux de manière inclinée à distance de la couverture de toit concernée.

Ainsi, les documents WO 2009/077030 et US 2009/0266406, par exemple, divulguent des supports sous forme de corps creux en matériaux plastiques aptes à recevoir des panneaux photovoltaïques soit dans des renfoncements adaptés (US 2009/0266406), soit entre des doigts de maintien supérieurs et inférieurs (WO 2009/077030), ces supports étant fixés par ancrage sur les toitures ou lestés pour résister au vent.

Ces supports modulaires, qui peuvent être associés à plusieurs pour former des arrangements, ne peuvent toutefois recevoir qu'un type dimensionnel de panneaux.

Par les documents FR 2 890 725 et FR 2 494 408, on connaît un châssis de montage et de fixation de panneaux photovoltaïques, comprenant des supports sous forme d'un cadre triangulaire articulé, formant une demi-ferme.

Ces supports sont assemblés entre eux pour créer une structure porteuse et sont fixés sur des pièces d'embase solidarisées par ancrage à la toiture. Leur mise en oeuvre nécessite un travail délicat et fastidieux sur chantier, requérant des opérateurs très qualifiés.

Les solutions connues précitées présentent, en plus des limitations déjà évoquées, également l'inconvénient de ne pas être adaptées à un montage sur des couvertures étanches formées par des membranes ou des feuilles bitumineuses, le lestage étant souvent incompatible avec la résistance à la contrainte de la couverture ou de ses éléments support et la fixation par ancrage traditionnel (vis, rivet, etc.) détériorant l'étanchéité de la couverture.

Par ailleurs, différents modes de fixation ou de liaisonnement d'un revêtement d'étanchéité à son support font partie de l'état de la technique et des connaissances de l'homme du métier. Ce support peut être constitué, par exemple, d'un isolant thermique, d'une dalle de béton, d'une couverture en bois ou en dérivés de bois, d'une couverture métallique ou autre.

En général, les revêtements d'étanchéité sont liaisonnés au support (par adhérence thermique ou adhésive, par semi-adhérence, par fixation mécanique) directement au niveau de l'élément porteur ou de la charpente, ou plus généralement avec interposition d'un isolant thermique entre l'élément porteur et ledit revêtement d'étanchéité. Ce liaisonnement permet notamment que l'étanchéité, formant la couche exposée, résiste aux effets de dépression et aux sollicitations d'arrachement du vent.

Lorsqu'aucun liaisonnement particulier du revêtement avec son support, ni directement avec l'élément porteur, n'est prévu, il est dit posé en indépendance. Dans ce cas, un lestage est nécessaire pour empêcher qu'il ne se détache de la toiture et qu'il ne s'envole, ce lestage se présentant par exemple sous forme de gravillons, de dalles, de dallettes ou d'autres éléments de couverture massifs, ce en fonction notamment de l'accessibilité ou non de la toiture concernée et de la résistance mécanique de l'élément porteur.

La présente invention concerne plus particulièrement des systèmes de toiture dans lesquels des éléments en plaques, panneaux ou analogues présentant un poids insuffisant pour résister à l'action du vent sont mis en place sur un revêtement d'étanchéité liaisonné à son support, ledit revêtement devant, par conséquent, contribuer à la résistance au vent des panneaux ou plaques rapporté(e)s.

Par le document DE 20 2009 005 202U1, on connaît déjà des blocs support pleins en matériau moussé avec une face supérieure inclinée, constituant des pièces support pour panneaux photovoltaïques.

Ces blocs comportent, sur leurs faces inférieures, des rails pour la fixation d'une membrane bitumineuse apte à être solidarisée au revêtement de la toiture.

Ces blocs comportent aussi, sur leurs faces supérieures, des rails transversaux (donc perpendiculaires au sens de la pente formée par l'inclinaison) pour la fixation des panneaux photovoltaïques, lesquels reposent sur toute la surface desdits blocs, dont la taille doit, par conséquent, être adaptée.

En plus de l'encombrement important des blocs mis en oeuvre, de la grande quantité de matière nécessaire à leur fabrication et de l'utilisation obligatoire de rails pour leur fixation inférieure sur la membrane, cette solution connue n'autorise pas un refroidissement satisfaisant de panneaux supportés.

Par le document DE-A-10 2007 019 596, on connaît, par ailleurs, un socle de montage de collecteurs solaires formé par un arrangement adjacent de pièces légères et creuses avec une surface supérieure inclinée, sur laquelle reposent les panneaux collecteurs.

Ces pièces support sont solidarisées au revêtement du toit, d'une part, par un bord de fixation périphérique en un matériau du type membrane ou film adhérant audit revêtement et, d'autre part, à l'intérieur des pièces creuses, par des plots à vis traversant ledit revêtement.

Compte tenu du mode de montage des panneaux, ces pièces support nécessitent la mise en oeuvre de pièces support de taille adaptée à celle des panneaux, avec un système de refroidissement intégré pour éviter les élévations de température trop importante. En outre, leur mise en oeuvre entraîne le percement au moins du revêtement supérieur de la toiture.

Dans ce contexte, l'invention a pour but de fournir une solution pour le support et la fixation d'éléments en plaques, panneaux ou analogues, en particulier de panneaux photovoltaïques, aptes à s'adapter à des panneaux de tailles différentes et ne nécessitant aucun lestage particulier, ni aucune fixation traversante susceptible d'interrompre ou de générer une discontinuité quelconque dans le revêtement étanche du toit ou surface support analogue.

De plus, la solution proposée devrait autorisée une bonne ventilation des faces arrière des panneaux et permettre un montage aisé d'accessoires tels que des conduits ou analogues.

En outre, la solution proposée devrait être simple à mettre en oeuvre sur site, être adaptée à une fabrication en grande série, ne pas générer de surpoids important et être d'un prix de revient modéré.

A cet effet, l'invention a pour objet un dispositif de support et de fixation d'éléments en forme de plaques, de panneaux ou analogues sur une couverture de toit de bâtiment, à distance de cette dernière, ladite couverture comportant en surface un revêtement ou une couche d'étanchéité rapporté(e) sur le support sensiblement continu formant le toit, sur une couche ou un revêtement d'étanchéité sous-jacent, ou sur une couche d'isolation thermique recouvrant ce support,
le dispositif comprenant des consoles d'appui et de maintien inclinés pour les éléments en forme de plaques, panneaux ou analogues, arrangés selon au moins un alignement, chacune de ces consoles présentant une partie inférieure destinée à prendre appui sur la surface de la couverture et à être solidarisée à cette dernière et au moins une partie supérieure destinée à supporter directement ou indirectement un ou plusieurs éléments en forme de plaques, panneaux ou analogues, lesdites consoles présentant, vues de côté, une structure triangulaire dont la base est formée par la partie inférieure et dont le ou les côté(s) définissant avec la base un angle aigu est(sont) formé(s) par la ou les partie(s) supérieure(s) assurant le support et le maintien inclinés,
chaque console consistant principalement en un corps creux, monobloc ou non,
la partie inférieure desdites consoles étant pourvue en sous-face d'au moins une portion de plaque, de panneau, de membrane ou de feuille, formant un plastron rapporté qui est solidarisé à la console, le ou chaque plastron consistant en un matériau, ou étant à base d'un matériau compatible et/ou de même nature que la couche ou le revêtement en surface de la couverture et étant lié à cette couche ou à ce revêtement par une liaison adhérente, dispositif caractérisé en ce que les parties supérieures des consoles comprennent une ou plusieurs portions de paroi dudit corps creux fournissant une ou plusieurs surface(s) d'appui allongée(s) pour les bords latéraux des panneaux ou analogues ou pour des profilés de montage de tels panneaux, chaque panneau ou analogue pouvant être supporté uniquement au niveau de ses bords latéraux opposés, éventuellement par l'intermédiaire de rails, par deux consoles mutuellement espacées d'un alignement.

L'invention sera mieux comprise, grâce à la description ci-après, qui se rapporte à des modes de réalisation préférés, donnés à titre d'exemple non limitatifs, et expliqués avec référence aux dessins schématiques annexés, dans lesquels :
Les figures 1 A et 1 B sont des vues en perspective d'une partie d'un dispositif de support et de fixation selon un mode de réalisation de l'invention, comprenant trois consoles d'appui et de maintien, et supportant respectivement deux et quatre panneaux ;
Les figures 2A et 2B sont des vues éclatées en perspective d'un corps creux d'une console selon deux variantes de réalisation de l'invention ;
La figure 3 est une vue en perspective du corps creux de la console de la figure 2B, avant fixation des plastrons ;
Les figures 4A et 4B sont des vues respectivement en perspective et en élévation latérale de la console représentée sur la figure 3, après fixation des plastrons ;
Les figures 5A, 5B et 5C sont des vues en coupe transversale selon A-A, B-B et C-C de la console représentée figure 4B ;
Les figures 6A et 6B sont respectivement des vues en élévation latérale interne et de dessus d'une demi-coque faisant partie d'une console telle que représentée de manière éclatée sur la figure 2B, les deux plaques comportant les sites d'ancrage ou d'accrochage étant en place (par emboîtement) ;
Les figures 6C, 6D et 6E sont des vues à une échelle différente des coupes A-A et B-B de la figure 6A et de la coupe C-C de la figure 6B ;
La figure 7A est une vue en perspective d'une console faisant partie du dispositif selon l'invention, munie d'un chemin de câble ;
La figure 7B est une vue de détail en élévation latérale d'un palier traversant pour chemin de câble d'une console telle que représentée sur la figure 7A, et,
La figure 8 est une vue éclatée d'un dispositif selon un autre mode de réalisation de l'invention.

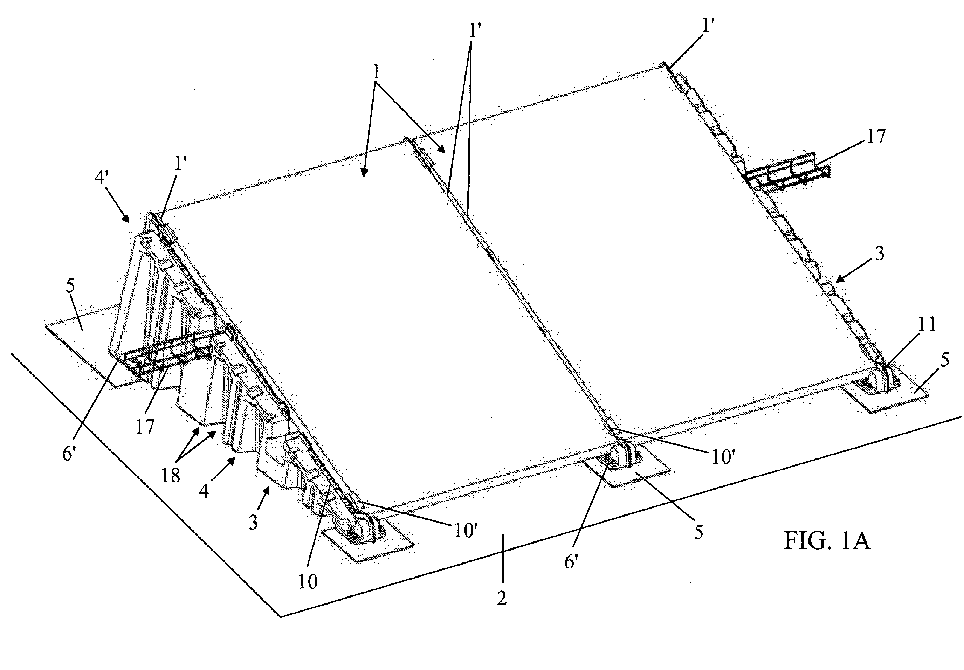

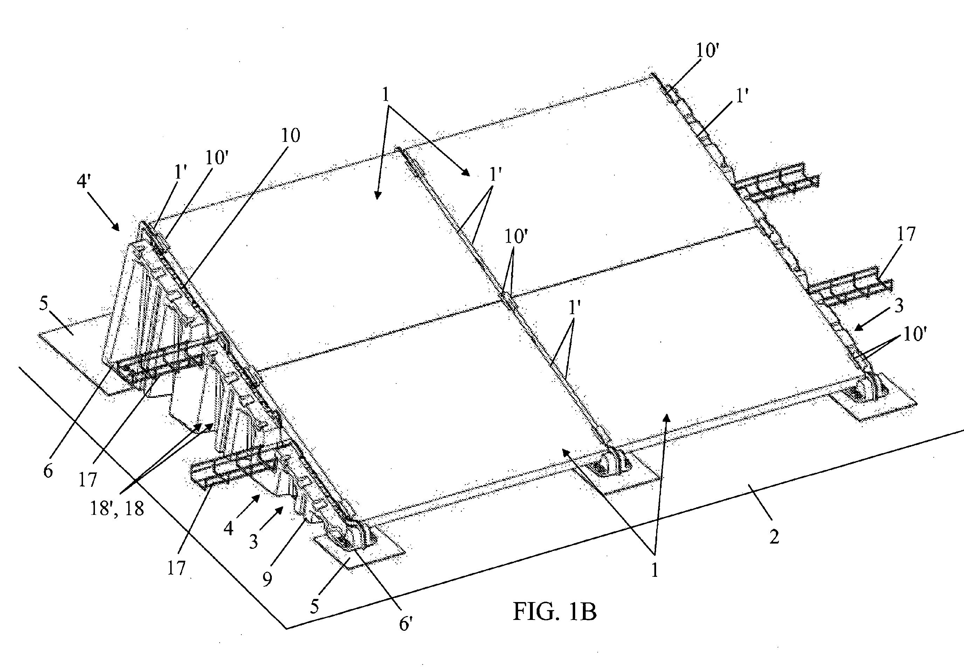

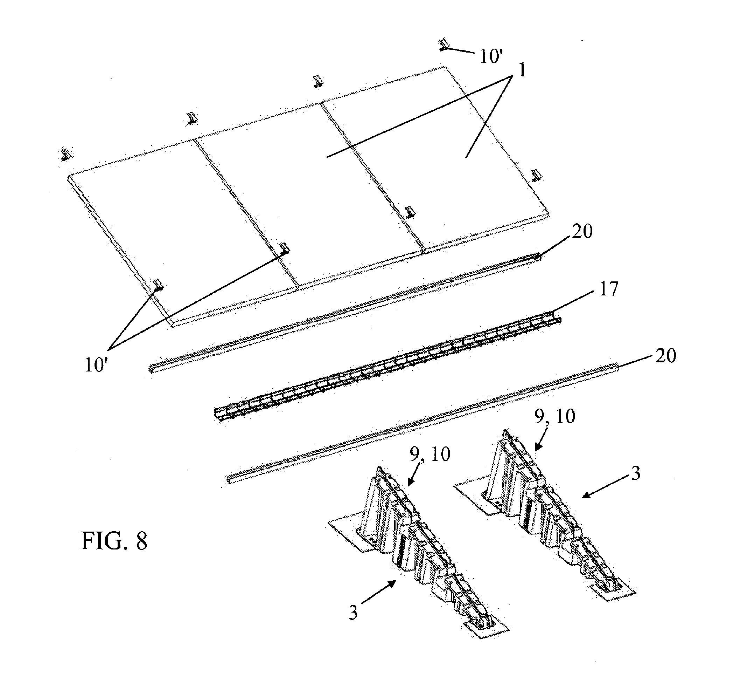

Les figures 1A, 1B et 8 des dessins annexés montrent partiellement un dispositif de support et de fixation d'éléments 1 en forme de plaques, de panneaux ou analogues sur une couverture 2 de toit de bâtiment, à distance de cette dernière, ladite couverture 2 comportant en surface un revêtement ou une couche d'étanchéité rapporté(e) sur le support sensiblement continu formant le toit, sur une couche ou un revêtement d'étanchéité sous-jacent, ou sur une couche d'isolation thermique recouvrant ce support.

Ce dispositif comprend des consoles 3 d'appui et de maintien inclinés pour les éléments 1 en forme de plaques, panneaux ou analogues, arrangés de manière mutuellement espacée selon au moins un alignement, chacune de ces consoles 3 présentant une partie inférieure 4 destinée à prendre appui sur la surface de la couverture et à être solidarisée à cette dernière et au moins une partie supérieure 4' destinée à supporter directement ou indirectement un ou plusieurs éléments 1 en forme de plaques, panneaux ou analogues, les consoles 3 présentant, vues de côté, une structure triangulaire dont la base est formée par la partie inférieure 4 et dont le ou les côté(s) définissant avec la base un angle aigu est(sont) formé(s) par la ou les partie(s) supérieure(s) 4' assurant le support et le maintien inclinés, chaque console consistant principalement en un corps creux, monobloc ou non.

Ce dispositif est caractérisé en ce que la partie inférieure 4 des consoles 3 est pourvue en sous-face d'au moins une portion 5 de plaque, de panneau, de membrane ou de feuille, formant un plastron rapporté qui est solidarisé à la console 3, le ou chaque plastron 5 consistant en un matériau, ou étant à base d'un matériau compatible et/ou de même nature que la couche ou le revêtement en surface de la couverture 2 et étant lié à cette couche ou à ce revêtement par une liaison adhérente.

En outre, chaque partie supérieure 4' comprend une ou plusieurs portions de paroi dudit corps creux 3' fournissant une ou plusieurs surface(s) d'appui 9 allongée(s) pour les bords latéraux 1' de panneaux ou analogues ou pour des profilés de montage de tels panneaux.

L'utilisation d'un tel ou de tels plastron(s) 5 de liaisonnement, intercalé(s) entre la partie inférieure 4 et la couche ou le revêtement d'étanchéité de la couverture 2, permet, d'une part, d'aboutir à une liaison très résistante avec une répartition des sollicitations en traction sur une grande zone de la couche ou du revêtement et, d'autre part, de limiter les sollicitations en cisaillement ou en coupe exercées au niveau du bord de la partie inférieure 4 sur ladite couche ou ledit revêtement (fonction de coussinet d'amortissement du plastron 5).

De plus, compte tenu de la nature du matériau formant ce plastron 5, son comportement en température (notamment en contraction et en dilatation) sera similaire, voire identique, à celui de la couche ou du revêtement supérieur(e) de la couverture 2, évitant la génération de contraintes au niveau de l'interface de contact entre ces deux composants.

Bien que d'autres types de liaisonnement puissent être envisagés, chaque plastron 5 est préférentiellement fixé mécaniquement à la partie inférieure correspondante et présente une résistance importante à la déformation et au déchirement.

En fonction notamment de la nature de la couche supérieure de la couverture 2 de l'application visée et/ou des performances recherchées, des plastrons 5 de type, de nature et de dimensions variés peuvent être associés à un même type de consoles 3.

Le support des panneaux ou analogues au niveau de leurs bords latéraux uniquement, éventuellement par l'intermédiaire de rails 20, autorise un refroidissement par circulation d'air en sous-face desdits panneaux.

Ce refroidissement est, en outre, facilité par l'arrangement mutuellement espacé des paires de consoles 3 supportant ensemble un tel panneau 1.

La partie inférieure 4 comporte des zones d'appui surfaciques 6, 6', 22, dont au moins une partie est associée à au moins un plastron 5.

Avantageusement, et comme le montrent les figures 1A, 1B, 3, 4A et 4B des dessins annexés, la partie inférieure 4 de chaque console 3 présente au moins une formation latérale 6, 6', du type méplat ou analogue, fournissant, le cas échéant chacune, une zone d'appui externe, destinée à coopérer par contact surfacique avec le ou un des plastron(s) 5 et pourvue de plusieurs orifices 6" pour la réception d'éléments 7 de fixation mécanique, ces derniers traversant le plastron 5 correspondant et étant associés chacun à une plaquette, éventuellement commune, ou à une rondelle 8 destinée à presser localement ledit plastron 5 contre ladite formation latérale 6, 6' par en-dessous.

De manière préférée, la partie inférieure 4 de chaque console 3 présente une zone d'appui surfacique externe au moins à chacune de ses extrémités longitudinales opposées, préférentiellement s'étendant symétriquement de chaque côté de la console 3 considérée, un plastron 5 étant fixé, préférentiellement mécaniquement, à chacune desdites extrémités, sous les zones d'appui surfaciques inférieures de formations latérales 6, 6' d'appui de ladite partie inférieure 4 et avec une extension surfacique respectivement supérieure à ces dernières.

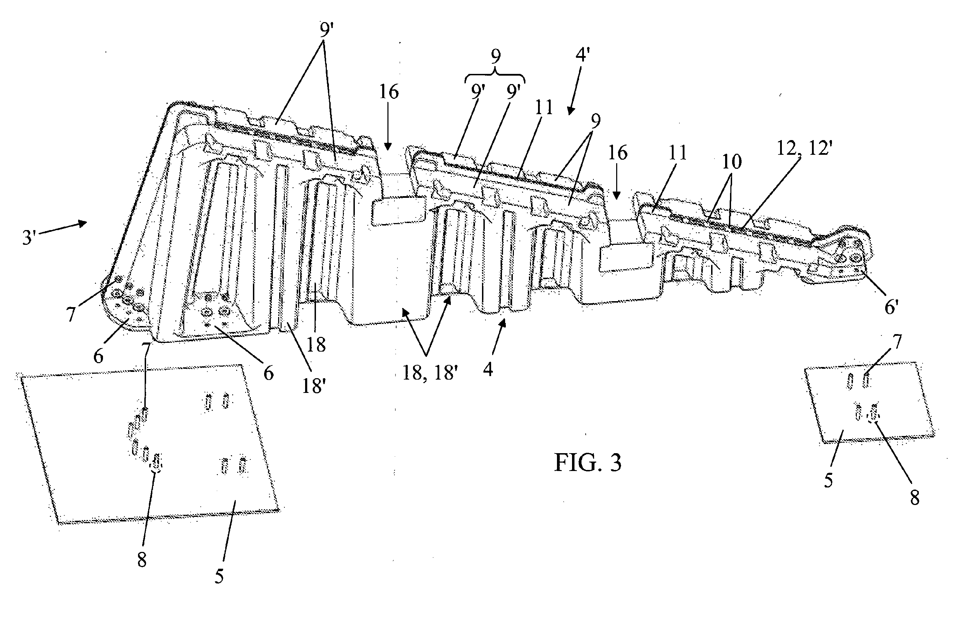

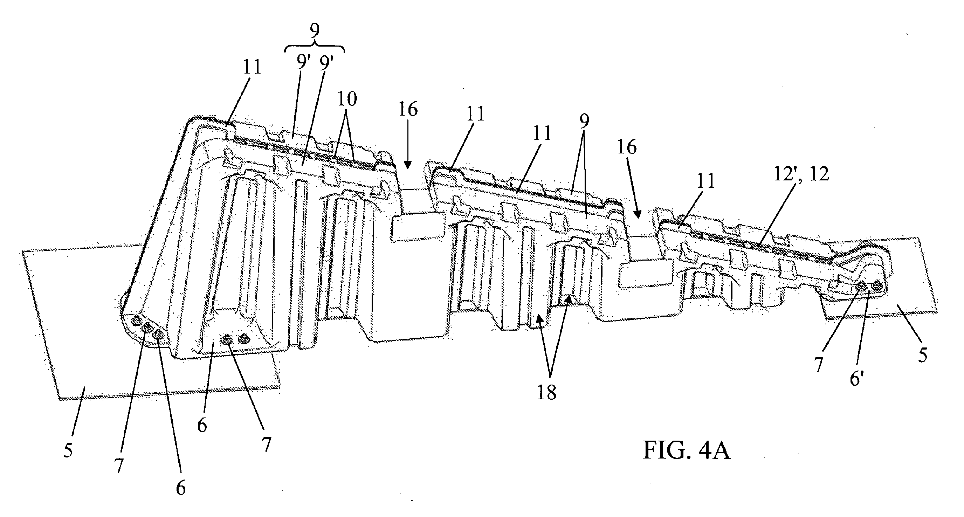

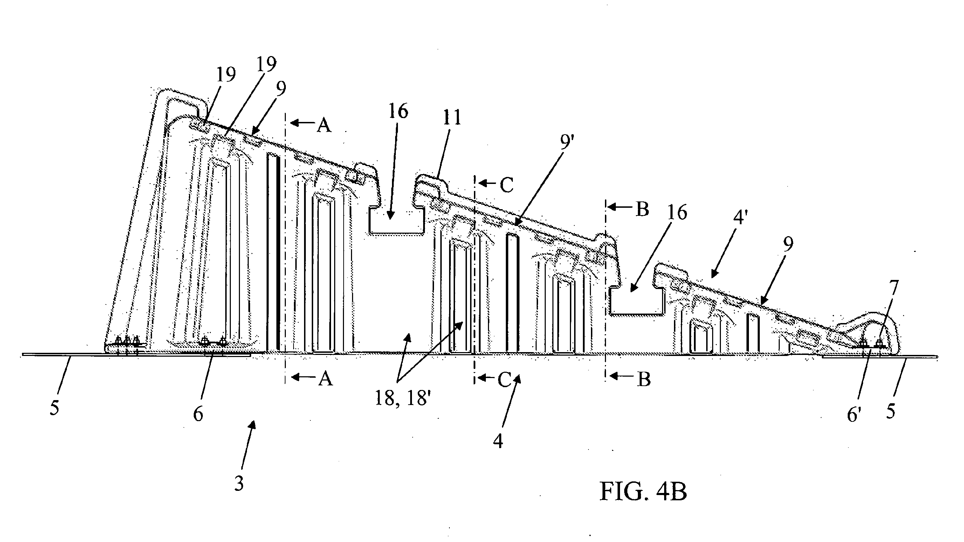

Comme le montrent notamment les figures 3, 4A et 4B des dessins annexés, les plastrons 5 s'étendent de manière continue sous la partie inférieure 4 de chaque console 3, au moins au niveau des zones de formations latérales 6, 6', voire sous la totalité de la surface de la sous-face de ladite partie inférieure 4 et au-delà du périmètre extérieur de cette dernière, ou au moins de ces formations.

La liaison adhérente surfacique entre le ou chaque plastron 5 et la couche ou le revêtement en surface de la couverture 2 peut être réalisée selon différentes techniques connues de l'homme du métier, ce le cas échéant en fonction de la nature et du type des matériaux constituant le plastron 5 considéré et la couche ou le revêtement de surface.

Ainsi, cette liaison adhérente surfacique peut consister par exemple en :
- une liaison par collage, l'agent collant étant un agent additionnel rapporté,
- une liaison par adhésion à froid, la sous-face du ou de chaque plastron 5 comportant un revêtement présentant des propriétés adaptées (par exemple sous-face autocollante).

Toutefois, en accord avec une variante de réalisation très avantageuse de l'invention, évitant la mise en oeuvre d'un agent collant additionnel ou d'un revêtement de sous-face particulier des plastrons 5, la liaison adhérente surfacique entre ce dernier et la couche ou le revêtement en surface de la couverture 2 est une liaison par soudure (par exemple à la flamme d'un chalumeau ou à l'air chaud), le plastron 5 et la couche ou revêtement en surface étant alors préférentiellement à base de membrane d'étanchéité bitumineuse ou synthétique.

En vue d'aboutir à une valeur de force d'adhérence maximale, la liaison adhérente surfacique entre chaque plastron 5 et la couche ou le revêtement en surface de la couverture 2 s'étend sensiblement à la totalité de la surface de la sous-face du plastron 5 considéré (les plaquettes ou rondelles 8 mentionnées précédemment correspondant à des zones adhérentes ou non à la couche ou au revêtement de surface).

Bien qu'une surface des plastrons supérieure à celle des zones d'appui des formations latérales 6, 6' permette d'atteindre des performances d'adhésion plus élevées, il est également possible d'envisager des surfaces égales, voire une surface inférieure pour un plastron 5, en particulier lorsque les performances recherchées sont plus limitées et/ou que la nature de la liaison fournit des performances suffisantes.

Aucune fonction d'étanchéité n'étant spécifiquement recherchée, ladite liaison adhérente peut être soit de nature continue au niveau de la sous-face des plastrons 5, soit de nature discontinue avec création de zones non liées, radiales ou périphériques.

A titre d'exemples non limitatifs de types de revêtements d'étanchéité, on peut citer, d'une part, ceux en bitume modifié, préférentiellement avec autoprotection, permettant un liaisonnement rapide des plastrons 5 et, d'autre part, ceux sous forme de membranes à base de résines synthétiques souples ou rigides (naturellement sans autoprotection).

Le revêtement d'étanchéité de surface de la couverture 2 peut être avantageusement un bicouche bitumineux, qui correspond à une solution à très haute fiabilité et durabilité, reposant directement sur le support ou généralement sur une couche d'isolation thermique.

A titre d'exemple pratique de revêtement d'étanchéité, on peut évoquer un système standard constitué de deux feuilles en bitume modifié par SBS, la première couche d'épaisseur 2,5 mm étant armée par un non tissé de voile de verre de 50 g/m², la deuxième couche étant également de 2,5 mm d'épaisseur et armée aussi par un voile de verre de 50 g/m².

Un système hautement renforcé cité comme exemple peut-être constitué de deux feuilles en bitume modifié SBS, la première de 2,5 mm d'épaisseur étant armée par un composite polyester-verre de 130 g/m² et la deuxième couche de 3,5 mm étant armée par un composite polyester-verre de 250 g/m².

Parmi les techniques connues de l'homme de l'art, le revêtement d'étanchéité est relié à son support au minimum en semi-indépendance et préférentiellement en adhérence.

L'exemple le plus courant de mode de pose en semi-indépendance est celui par fixation mécanique directement liée à l'élément porteur ou au support.

Comme indiqué précédemment, un système bicouche devrait être privilégié. Les feuilles de première couche sont alors assemblées selon la description développée par exemple dans l'Avis technique 5/06-1903, en étant posées librement sur leur support qui est en général un panneau isolant de 10 cm d'épaisseur par exemple, puis leurs recouvrements de plusieurs centimètres de largeur et incluant la fixation mécanique traversante sont soudés afin de les rendre étanches. Les feuilles de la deuxième couche sont ensuite soudées en plein sur celles de la première couche.

Comme déjà indiqué précédemment, il y a de manière générale pratiquement toujours un isolant sous le revêtement d'étanchéité.

Les isolants particulièrement adaptés dans le cadre de l'invention en tant que supports de l'étanchéité sont de classe C en résistance à la compression selon le guide UEATC et se présentent généralement sous la forme de panneaux.

Il est entendu par ailleurs que tout panneau isolant apte à recevoir, en pleine adhérence ou semi-adhérence, un revêtement d'étanchéité fait état de sa propre performance vis-à-vis du vent, fonction notamment de sa cohésion interne. Cette aptitude est déduite généralement de sa résistance en traction perpendiculaire aux deux faces du panneau isolant.

Les plastrons 5 susceptibles d'être utilisés dans le cadre de l'invention peuvent être de différents types et de différentes natures de matériaux.

Ainsi, selon une première variante pratique, le ou chaque plastron 5 peut consister en une partie de feuille ou de membrane bitumineuse (par exemple de taille 40 cm x 40 cm) avec soit une face supérieure autoprotégée par paillettes d'ardoise, soit une face supérieure en bitume modifié par SEBS résistant aux UV.

La feuille autoprotégée par paillettes, définie dans son Avis technique CSTB n° 5/08-1993, est une membrane d'épaisseur 4 mm à base de bitume modifié par élastomère SBS, armée par un support polyester non tissé de 250 g/m² à forte résistance mécanique en traction (de l'ordre de 1000 N/5 cm selon EN 12311-1) et une résistance importante à la déchirure au clou (de l'ordre de 300 N selon EN 12310-1).

La feuille avec surface en bitume modifié par SEBS, définie dans son Avis technique CSTB n° 21/09-06, est une membrane de 3,5 mm d'épaisseur, armée par un support composite polyester-verre de 250 g/m2 de résistance en traction de 1500 N/5 cm et une aptitude vis-à-vis de la déchirure de 250 N environ.

La feuille bitumineuse peut également être à base de bitume modifié par PPA (polypropylène atactique), avec une face supérieure sans autoprotection.

Conformément à une seconde variante pratique, le ou chaque plastron 5 peut consister en une portion de membrane synthétique souple du type TPO (thermoplastiques polyoléfines) ou PVC (polychlorure de vinyle), par exemple de 30 cm x 30 cm.

Ces deux membranes synthétiques, par exemple d'épaisseur 1,5 mm, peuvent être armées par une grille de polyester de 110 g/m² à forte résistance en traction (d'au moins 1000 N /5 cm selon EN 12311-2) et à aptitude très élevée contre la déchirure (250 N selon EN 12310-2).

Conformément à une troisième variante pratique, le ou chaque plastron 5 peut consister en une plaque ou membrane synthétique rigide (par exemple de 20 cm x 20 cm) à base par exemple de PEHD (polyéthylène haute densité). Une telle membrane synthétique a une résistance mécanique en traction et une aptitude vis-à-vis de la déchirure suffisantes sans que cette membrane ne soit armée.

Enfin, il peut également être envisagé de mettre en oeuvre un plastron 5 à deux composantes (structure stratifiée), la composante supérieure étant compatible avec la console 3 et la composante inférieure avec le revêtement d'étanchéité de la couverture 2.

Comme le montrent également les figures des dessins annexés, et en accord avec un mode de réalisation de l'invention fournissant une solution légère, rigide, aisée à fabriquer et à mettre en oeuvre, il est prévu que chaque console 3 consiste en un corps creux 3', monobloc ou non, obtenu par moulage ou thermoformage d'un matériau polymère. De plus, la partie supérieure 4' comprend une ou plusieurs portion(s) de paroi dudit corps creux 3' qui fourni(ssen)t une ou plusieurs surface(s) d'appui 9 allongée(s) pour le bord latéral (1') d'un panneau photovoltaïque 1 ou autre, pour les bords latéraux 1' d'au moins deux panneaux photovoltaïques ou autres montés côte à côte (les bords l'étant adjacents au niveau des consoles) ou pour des profilés 20 de montage de tels panneaux 1 ou analogues (figures 1A et 1B).

Les panneaux 1 ou analogues peuvent, par conséquent, soit reposer directement sur les parties supérieures des consoles 3, l'écartement entre ces dernières étant alors adapté à l'une des dimensions (longueurs ou largeurs) desdits panneaux rectangulaires, soit être montés sur des profilés intermédiaires 20, sensiblement de manière mutuellement adjacente, ces profilés étant fixés sur les consoles 3 (l'écartement entre ces dernières ne dépendant alors que de la charge à supporter).

Bien entendu, les consoles 3 situées en fin d'alignement ne supporteront des panneaux 1 que d'un seul côté.

En vue de fournir un maintien rigide et résistant aux panneaux 1 ou analogues, tout en autorisant un montage et un démontage aisés de ces derniers, chaque console 3 comporte avantageusement une pluralité de sites d'accrochage ou d'ancrage 10 pour des moyens de solidarisation amovibles 10' pour une fixation latérale des panneaux ou analogues 1 directement supportés par la console 3 considérée ou pour une fixation de profilés intermédiaires 20 de montage de tels panneaux ou analogues 1, ces sites 10 étant répartis le long des surfaces d'appui allongées 9 de la partie supérieure 4 de la console 3 considérée

Conformément à une réalisation pratique préférée des consoles 3, chaque surface d'appui allongée 9 est subdivisée, dans le sens de sa plus grande longueur, par des moyens de butée 11 en deux surfaces élémentaires 9', aptes chacune à supporter un bord latéral 1' ou une partie d'un bord latéral 1' d'un panneau ou analogue 1 et les sites d'accrochage ou d'ancrage 10 se présentent sous la forme de perforations ménagées dans une ou plusieurs plaques métalliques 12 intégrées dans le corps creux 3' de la console 3 concernée.

Le corps creux 3', préférentiellement en un matériau thermoplastique ou éventuellement thermodurcissable, peut, bien entendu, être fabriqué d'un seul tenant par moulage, la ou les plaque(s) 12 étant alors prépositionnée(s) dans le moule correspondant et au moins partiellement surmoulée(s).

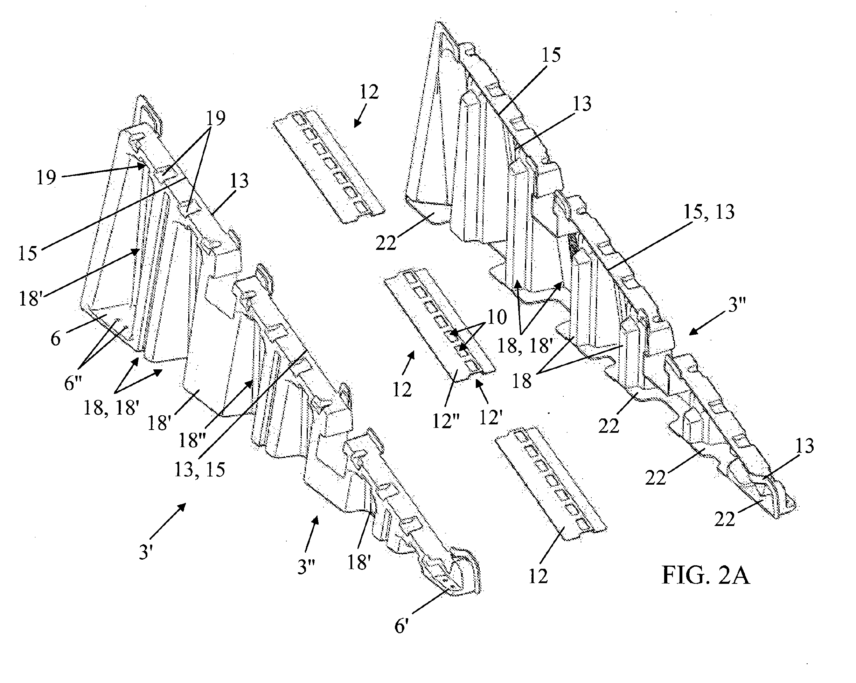

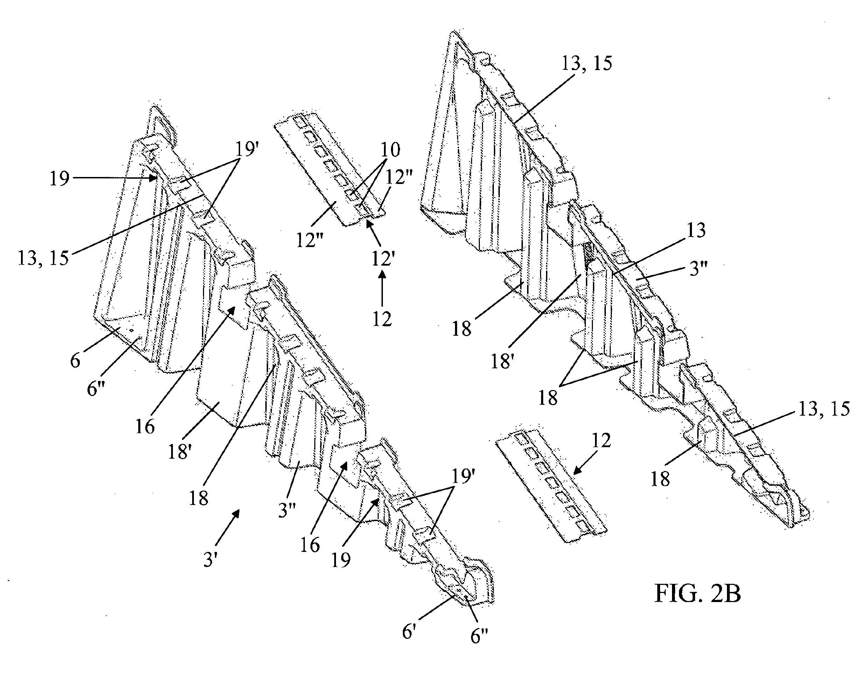

Toutefois, en accord avec une variante de réalisation très avantageuse de l'invention ressortant notamment des figures 2A et 2B des dessins annexés, le corps creux 3' est composé de deux demi-coques 3" complémentaires, ayant des formes symétriques, et assemblées entre elles selon un plan médian au moins au niveau des bords périphériques 13 en contact desdites demi-coques 3", et éventuellement au niveau de formations 18, saillantes vers l'intérieur et en contact mutuel, des deux demi-coques 3".

L'assemblage entre les demi-coques 3" peut éventuellement combiner un assemblage mécanique, par exemple par coopération de forme complémentaire, avec un assemblage par collage, soudure ou analogue.

Ces deux demi-coques peuvent consister en un matériau synthétique, comme indiqué précédemment, ou en variante en un matériau métallique, par exemple à base d'aluminium, en acier traité (tôle) ou en acier inoxydable.

Comme le montrent les figures 2 à 6 des dessins annexés, il peut être prévu qu'à au moins certaines des surfaces d'appui allongées 9 de la partie supérieure 4 de chaque console 3 sont associés des sites 10 d'accrochage ou d'ancrage pour des moyens amovibles 10' de fixation latérale des panneaux 1 ou analogues sous la forme de plaques métalliques 12 allongées et percées le long d'une bande centrale 12', ces plaques 12 comportant de part et d'autre de ladite bande centrale 12' des ailes latérales 12" destinées à s'emboîter dans des interstices de réception 14 adaptés formés dans, à proximité ou sous les portions de paroi 9 formant la partie supérieure 4' de la console 3, de telle manière que lesdites plaques métalliques allongées 12 sont maintenues rigidement dans le corps creux 3' par emboîtements opposés après assemblage des deux demi-coques 3", la bande centrale 12' perforée de chaque plaque 12 présentant les sites d'accrochage ou d'ancrage 10 étant apparente à travers une ouverture formée par coopération de découpes adaptées 15 des portions de paroi 9 des deux demi-coques 4'.

Ainsi, la solidarisation des plaques 12 dans la console 3 est réalisée de manière purement mécanique, sans nécessiter de moyens de fixation supplémentaires.

Plus précisément et à titre d'exemple non limitatif représenté plus particulièrement aux figures 4, 5 et 6 des dessins annexés, chaque demi-coques 3" peut comporter, au niveau de la partie supérieure 4' de la console 3 considérée, des déformations locales 19, 19' de la paroi latérale et des portions de paroi formant les surfaces d'appui allongée 9, qui définissent par coopération les interstices de réception 14 pour les ailes latérales 12" des plaques 12.

Certaines 19 au moins de ces déformations locales 19, 19' peuvent consister en des portions d'extrémité de formations de renforcement et de rigidification 18 du corps creux 3'.

Ces déformations locales 19 et 19' alternées présentent des surfaces de contact en opposition, mais décalées, dont l'espacement est tel qu'il autorise avantageusement une rétention avec éventuel pincement des ailes latérales 12" des plaques 12.

Des déformations supplémentaires 19" de la paroi de la demi-coque 3" peuvent éventuellement amener un calage longitudinal de ces plaques 12.

Les parties des déformations 19 et 19' en contact avec les ailes 12" présentent avantageusement des surfaces de contact planes avec ces dernières, formant les parois discontinues de l'interstice correspondant 14 en forme de fente.

Les formations 18 peuvent accroître, le cas échéant, l'amplitude de l'évasement vers le bas des corps creux 3" des consoles 3, et se terminer elles-mêmes en des méplats 22.

En vue de s'affranchir d'un éventuel espacement des consoles 3 imposé par les dimensions des panneaux 1, et éventuellement pour augmenter la densité d'implantation desdits panneaux 1, le dispositif selon l'invention peut, comme le montrent par exemple la figure 8 des dessins annexés, également comprendre, pour chaque alignement de consoles 3, au moins deux profilés 20 s'étendant parallèlement dans la direction de l'alignement de consoles 3, reposant sur les surfaces d'appui 9 allongées et solidarisés aux sites d'ancrage ou d'accrochage 10, ces profilés 20 présentant des sites de solidarisation amovibles pour les panneaux 1 ou analogues, permettant un montage adjacent à côté de ces derniers sur lesdits profilés 20.

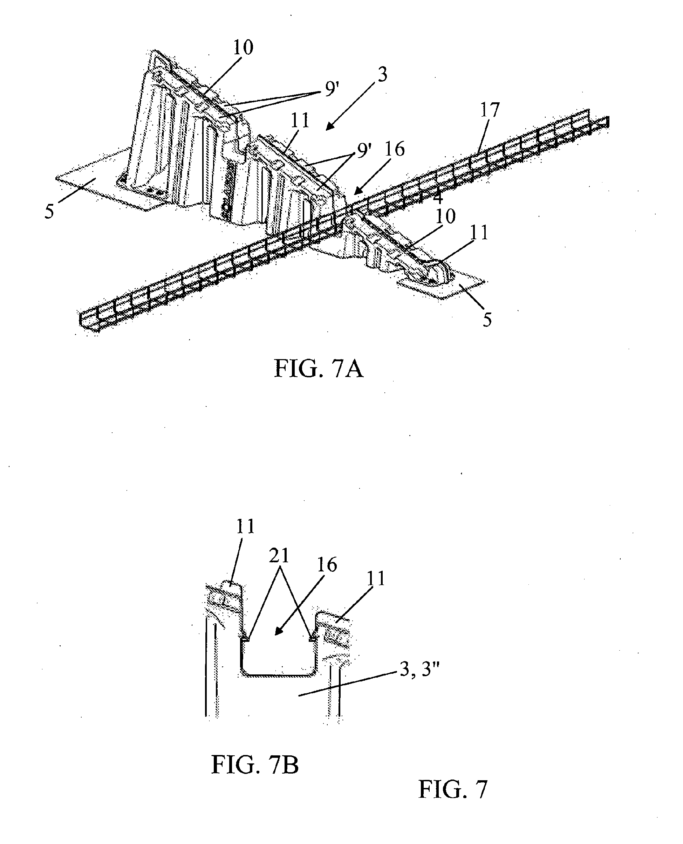

Conformément à une caractéristique supplémentaire de l'invention, ressortant notamment des figures 1A, 1B, 3, 4, 7A et 7B, la partie supérieure 4' du corps creux 3' de chaque console 3 comporte plusieurs surfaces d'appui allongées 9, séparées entre elles par une ou des cavité(s) ou échancrure(s) transversales traversantes 16 constituées par des déformations locales de sa paroi du corps creux 3' et adaptées pour constituer chacune un palier support pour un élément allongé 17 du type conduit, canal, goulotte, chemin de câble ou analogue.

Les paliers support 16 peuvent éventuellement comporter des moyens, par exemple sous la forme de crans, de blocage des goulottes 17.

Préférentiellement, le corps creux 3' de chaque console 3, éventuellement formé par assemblage de deux demi-coques 3" thermoformées, est réalisé en un matériau polymère choisi dans le groupe formé par le polyéthylène haute densité (PEHD), le polycarbonate, un mélange ABS/PMMA et le polypropylène.

Dans le cas d'une constitution en ABS/PMMA, les parois du corps creux 3' présente avantageusement une structure double avec une composante intérieure structurelle en ABS, fournissant la résistance mécanique, et une composante extérieure protectrice en PMMA (protection contre les rayonnements UV et plus généralement les agents climatiques et atmosphériques).

Il convient de noter que les matériaux polymères précités peuvent être au moins partiellement des matériaux recyclés.

De plus, afin d'augmenter la résistance en compression du corps creux 3' et d'augmenter la stabilité de son positionnement sur la couverture 2, ledit corps creux 3' peut comporter des formations de renforcement 18, 18' en creux et en saillie au niveau de ses parois latérales, ces dernières étant divergentes en direction de la partie inférieure 4 du corps creux 3', les deux demi-coques 3" étant, le cas échéant, assemblées par collage, soudure, enclenchement élastique ou à crans, fixation mécanique, par exemple par vis/écrous, ou analogues.

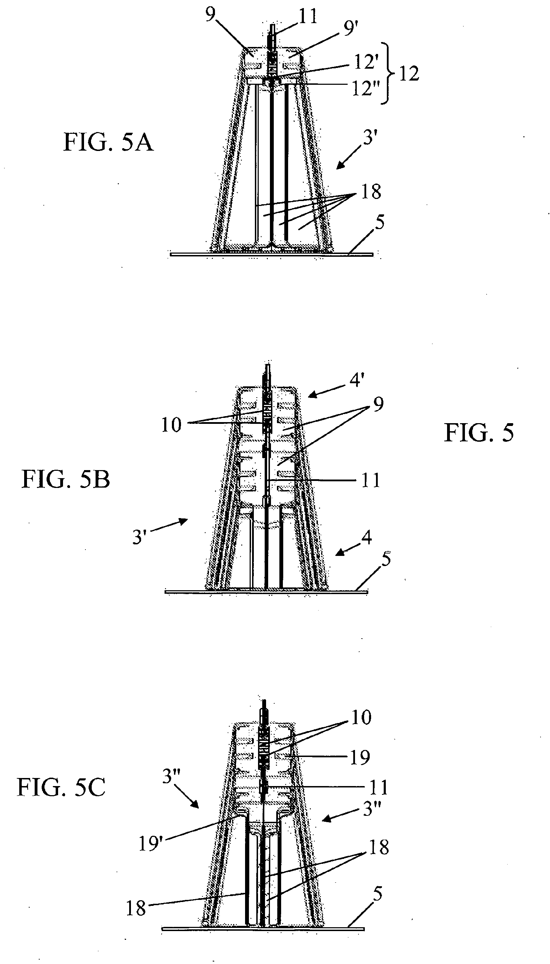

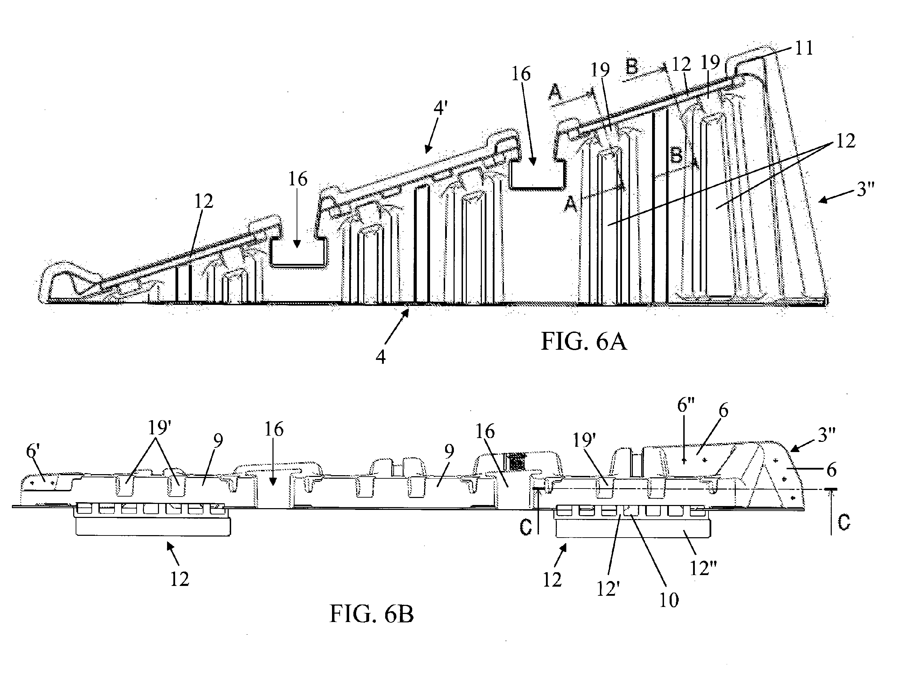

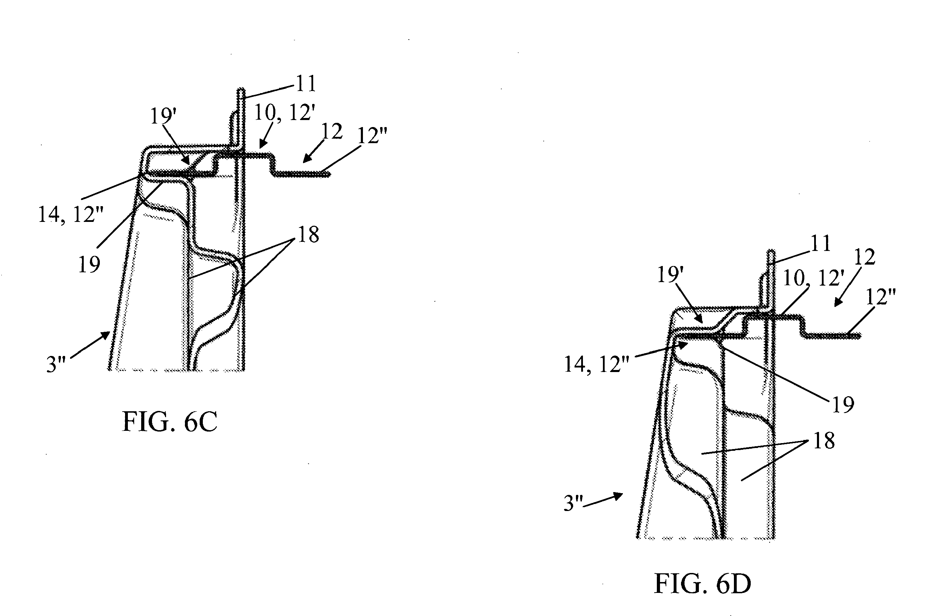

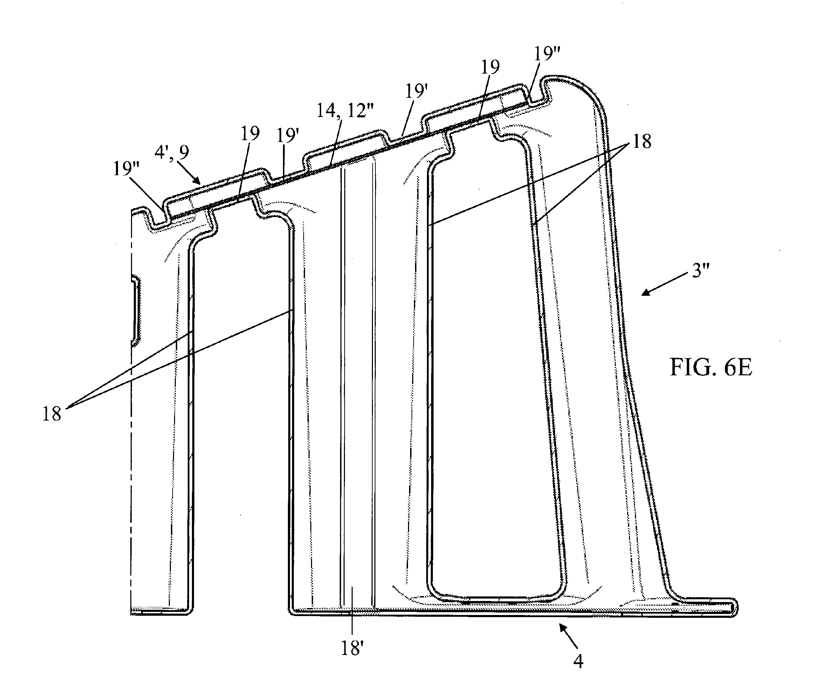

En accord avec un mode de réalisation pratique avantageux de l'invention ressortant de manière évidente des figures 5 et 6 des dessins annexés, les corps creux 3' des consoles 3 présentent une forme évasée depuis leur partie supérieure 4' vers leur partie inférieure 4, présentant ainsi une forme tronconique en section transversale.

De manière avantageuse, la partie inférieure 4 de chaque console 3 présente une structure ouverte en sous-face et le corps creux 3' correspondant comporte, en plus des formations latérales externes 6, 6', également des formations latérales internes 22, par exemple sous la forme d'ailes prolongeant l'extrémité des parois latérales, constituant des zones d'appui au niveau des bords inférieurs des parois dudit corps creux 3'.

Malgré une structure ajourée et découpée en sous-face (moins de matière, facilité de fabrication, évacuation d'eau), on aboutit ainsi à une stabilité latérale augmentée, à une surface d'appui plus importante réduisant les contraintes de compression sur le matériau isolant sous-jacent et, enfin, à l'aménagement automatique d'un espace entre les parties supérieures 4' de deux consoles 3 adjacentes, autorisant notamment un passage pour la circulation d'air.

L'invention concerne également un système de toiture à deux composantes intégrées comprenant une couverture étanche inférieure avec un revêtement ou une couche d'étanchéité en surface, préférentiellement une membrane d'étanchéité synthétique ou bitumineuse, et une couche supérieure composée d'éléments en forme de plaques, panneaux ou analogues, notamment des panneaux photovoltaïques, située à distance de la couverture étanche inférieure.

Ce système est caractérisé en ce que les éléments 1 de la couche supérieure sont portés et retenus sur la couverture 2 par un dispositif de support et de fixation tel que décrit précédemment et représenté aux dessins annexés.

Préférentiellement, la couverture étanche 2 présente en surface une membrane d'étanchéité bitumineuse, faisant éventuellement partie d'un complexe d'étanchéité à deux couches superposées, et les éléments 1 de la couche supérieure consistent en des panneaux photovoltaïques.

Enfin, la présente invention vise également une console 3 d'appui et de maintien inclinée destinée à faire partie d'un dispositif de support et de fixation d'éléments en forme de plaques 1, tel que décrit précédemment.

Cette console 3 est essentiellement constituée d'un corps creux 3' de forme triangulaire, avec une partie inférieure 4 destinée à prendre appui sur la surface de la couverture 2 et à être solidarisée à cette dernière et au moins une partie supérieure 4' destinée à supporter directement ou indirectement un ou plusieurs éléments en forme de plaques, panneaux ou analogues 1, cette console 3 présentant, vue de côté, une structure triangulaire dont la base est formée par la partie inférieure 4 et dont le ou les côté(s) définissant avec la base un angle aigu est(sont) formé(s) par la ou les partie(s) supérieure(s) 4' assurant le support et le maintien inclinés.

La console 3 pourra présenter une forme triangulaire isocèle, triangulaire rectangle ou encore triangulaire quelconque avec des parties supérieures d'inclinaison différente.

Préférentiellement, la console 3 présente une face supérieure de support privilégiée correspondant à une face d'inclinaison aigue par rapport à la face d'appui de la partie inférieure 4.

Conformément à l'invention, la partie inférieure 4 est pourvue en sous-face d'au moins une portion 5 de plaque, de panneau, de membrane ou de feuille, formant un plastron rapporté qui est solidarisé à ladite partie inférieure 4, le ou chaque plastron 5 consistant en un matériau, ou étant à base d'un matériau compatible et/ou de même nature que la couche ou le revêtement en surface de la couverture 2 et étant lié à cette couche ou à ce revêtement par une liaison adhérente.

Le corps de la console 3 est creux et la partie supérieure 4' comprend une ou plusieurs portions de paroi dudit corps creux 3' fournissant une ou plusieurs surface(s) d'appui 9 allongée(s) pour les bords latéraux 1' de panneaux ou analogues ou pour un profilé 20 de montage de ces derniers.

Avantageusement, le corps creux 3' est composé de deux demi-coques 3" complémentaires, ayant des formes symétriques, et assemblées entre elles selon un plan médian au moins au niveau des bords périphériques 13 en contact desdites demi-coques 3", et éventuellement au niveau de formations 18 saillantes vers l'intérieur et en contact mutuel des deux demi-coques 3", et en ce qu'à au moins certaines des surfaces d'appui allongées 9 de la partie supérieure 4 sont associés des sites 10 d'accrochage ou d'ancrage pour des moyens amovibles 10' de fixation latérale des panneaux 1 ou analogues sous la forme de plaques métalliques 12 allongées et percées le long d'une bande centrale 12', ces plaques 12 comportant de part et d'autre de ladite bande centrale 12' des ailes latérales 12" s'emboîtant dans des interstices de réception 14 adaptés formés dans, à proximité ou sous les portions de paroi 9 formant la partie supérieure 4', de telle manière que lesdites plaques métalliques allongées 12 formant inserts rigidement dans le corps creux 3' par emboîtements opposés dans les interstices 14 des deux demi-coques 3" assemblées, la bande centrale 12' perforée de chaque plaque 12 présentant les sites d'accrochage ou d'ancrage 10 étant apparente à travers une ouverture formée par coopération de découpes adaptées 15 des portions de paroi 9 des deux demi-coques 4'.

Préférentiellement, chaque demi-coques 3" comporte, au niveau de la partie supérieure 4', des déformations locales 19, 19' de la paroi latérale et des portions de paroi formant les surfaces d'appui allongée 9, qui définissent par coopération les interstices de réception 14 pour les ailes latérales 12" des plaques 12.

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention.

## Revendications

1. Dispositif de support et de fixation d'éléments (1) en forme de plaques, de panneaux ou analogues sur une couverture (2) de toit de bâtiment, à distance de cette dernière, ladite couverture comportant en surface un revêtement ou une couche d'étanchéité rapporté(e) sur le support sensiblement continu formant le toit, sur une couche ou un revêtement d'étanchéité sous-jacent, ou sur une couche d'isolation thermique recouvrant ce support,
le dispositif comprenant des consoles (3) d'appui et de maintien inclinés pour les éléments (1) en forme de plaques, panneaux ou analogues, arrangés selon au moins un alignement, chacune de ces consoles (3) présentant une partie inférieure (4) destinée à prendre appui sur la surface de la couverture et à être solidarisée à cette dernière et au moins une partie supérieure (4') destinée à supporter directement ou indirectement un ou plusieurs éléments (1) en forme de plaques, panneaux ou analogues, lesdites consoles (3) présentant, vues de côté, une structure triangulaire dont la base est formée par la partie inférieure et dont le ou les côté(s) définissant avec la base un angle aigu est(sont) formé(s) par la ou les partie(s) supérieure(s) assurant le support et le maintien inclinés,
chaque console consistant principalement en un corps creux, monobloc ou non,
la partie inférieure (4) desdites consoles (3) étant pourvue en sous-face d'au moins une portion (5) de plaque, de panneau, de membrane ou de feuille, formant un plastron rapporté qui est solidarisé à la console (3), le ou chaque plastron (5) consistant en un matériau, ou étant à base d'un matériau compatible et/ou de même nature que la couche ou le revêtement en surface de la couverture (2) et étant lié à cette couche ou à ce revêtement par une liaison adhérente,
dispositif **caractérisé en ce que** les parties supérieures (4') des consoles (3) comprennent une ou plusieurs portions de paroi dudit corps creux (3') fournissant une ou plusieurs surface(s) d'appui (9) allongée(s) pour les bords latéraux (1') des panneaux (1) ou analogues ou pour des profilés (20) de montage de tels panneaux, chaque panneau (1) ou analogue pouvant être supporté uniquement au niveau de ses bords latéraux opposés, éventuellement par l'intermédiaire de rails (20), par deux consoles (3) mutuellement espacées d'un alignement.

2. Dispositif selon la revendication 1, **caractérisé en ce que** la partie inférieure (4) de chaque console (3) présente au moins une formation latérale (6, 6'), du type méplat ou analogue, fournissant, le cas échéant chacune, une zone d'appui externe, destinée à coopérer par contact surfacique avec le ou un des plastron(s) (5) et pourvue de plusieurs orifices (6") pour la réception d'éléments (7) de fixation mécanique, ces derniers traversant le plastron (5) correspondant et étant associés chacun à une plaquette, éventuellement commune, ou à une rondelle (8) destinée à presser localement ledit plastron (5) contre ladite formation latérale (6, 6') par en-dessous.

3. Dispositif selon la revendication 1 ou 2, **caractérisé en ce que** la partie inférieure (4) de chaque console (3) présente une zone d'appui surfacique externe au moins à chacune de ses extrémités longitudinales opposées, préférentiellement s'étendant symétriquement de chaque côté de la console (3) considérée, un plastron (5) étant fixé, préférentiellement mécaniquement, à chacune desdites extrémités, sous les zones d'appui surfaciques inférieures de formations latérales (6, 6') d'appui de ladite partie inférieure (4) et avec une extension surfacique respectivement supérieure à ces dernières.

4. Dispositif selon l'une quelconque des revendications 1 à 3, **caractérisé en ce que** la liaison adhérente surfacique entre le ou chaque plastron (5) et la couche ou le revêtement en surface de la couverture (2) est une liaison par collage, l'agent collant étant un agent additionnel rapporté.

5. Dispositif selon l'une quelconque des revendications 1 à 3, **caractérisé en ce que** la liaison adhérente surfacique entre le ou chaque plastron (5) et la couche ou le revêtement en surface de la couverture (2) est une liaison par adhésion à froid, la sous-face du plastron (5) comportant un revêtement présentant des propriétés adaptées.

6. Dispositif selon l'une quelconque des revendications 1 à 3, **caractérisé en ce que** la liaison adhérente surfacique entre le ou chaque plastron (5) et la couche ou le revêtement en surface de la couverture (2) est une liaison par soudure, le plastron (5) et la couche ou revêtement en surface étant préférentiellement à base de membrane d'étanchéité bitumineuse ou synthétique.

7. Dispositif selon l'une quelconque des revendications 1 à 6, **caractérisé en ce que** la liaison adhérente surfacique entre le ou chaque plastron (5) et la couche ou le revêtement en surface de la couverture (2) s'étend sensiblement à la totalité de la surface de la sous-face du plastron (5) considéré.

8. Dispositif selon l'une quelconque des revendications 1 à 7, **caractérisé en ce que** chaque console (3) consiste en un corps creux (3') obtenu par moulage ou thermoformage d'un matériau polymère et **en ce que** la ou les portion(s) de paroi dudit corps creux (3') de la partie supérieure (4') foumisse(nt) une ou plusieurs surface(s) d'appui (9) allongée(s) pour le bord latéral (1') d'un panneau photovoltaïque (1) ou autre, pour les bords latéraux (1') d'au moins deux panneaux photovoltaïques montés côte à côte ou pour des profilés (20) de montage de tels panneaux (1).

9. Dispositif selon la revendication 8, **caractérisé en ce que** chaque console (3) comporte une pluralité de sites d'accrochage ou d'ancrage (10) pour des moyens de solidarisation amovibles (10') pour une fixation latérale des panneaux ou analogues (1) directement supportés par la console (3) considérée ou pour une fixation de profilés intermédiaires (20) de montage de tels panneaux ou analogues (1), ces sites (10) étant répartis le long des surfaces d'appui allongées (9) de la partie supérieure (4) de la console (3) considérée

10. Dispositif selon la revendication 9, **caractérisé en ce que** chaque surface d'appui allongée (9) est subdivisée, dans le sens de sa plus grande longueur, par des moyens de butée (11) en deux surfaces élémentaires (9'), aptes chacune à supporter un bord latéral (1') ou une partie d'un bord latéral (1') d'un panneau ou analogue (1) et **en ce que** les sites d'accrochage ou d'ancrage (10) se présentent sous la forme de perforations ménagées dans une ou plusieurs plaques métalliques (12) intégrées dans le corps creux (3') de la console (3) concernée.

11. Dispositif selon l'une quelconque des revendications 8 à 10, **caractérisé en ce que** le corps creux (3') est composé de deux demi-coques (3") complémentaires, ayant des formes symétriques, et assemblées entre elles selon un plan médian au moins au niveau des bords périphériques (13) en contact desdites demi-coques (3"), et éventuellement au niveau de formations (18), saillantes vers l'intérieur et en contact mutuel, des deux demi-coques (3").

12. Dispositif selon la revendication 11, **caractérisé en ce qu'**à au moins certaines des surfaces d'appui allongées (9) de la partie supérieure (4) de chaque console (3) sont associés des sites (10) d'accrochage ou d'ancrage pour des moyens amovibles (10') de fixation latérale des panneaux (1) ou analogues sous la forme de plaques métalliques (12) allongées et percées le long d'une bande centrale (12'), ces plaques (12) comportant de part et d'autre de ladite bande centrale (12') des ailes latérales (12") destinées à s'emboîter dans des interstices de réception (14) adaptés formés dans, à proximité ou sous les portions de paroi (9) formant la partie supérieure (4') de la console (3), de telle manière que lesdites plaques métalliques allongées (12) sont maintenues rigidement dans le corps creux (3') par emboîtements opposés après assemblage des deux demi-coques (3"), la bande centrale (12') perforée de chaque plaque (12) présentant les sites d'accrochage ou d'ancrage (10) étant apparente à travers une ouverture formée par coopération de découpes adaptées (15) des portions de paroi (9) des deux demi-coques (4').

13. Dispositif selon la revendication 12, **caractérisé en ce que** chaque demi-coques (3") comporte, au niveau de la partie supérieure (4') de la console (3) considérée, des déformations locales (19, 19') de la paroi latérale et des portions de paroi formant les surfaces d'appui allongée (9), qui définissent par coopération les interstices de réception (14) pour les ailes latérales (12") des plaques (12).

14. Dispositif selon l'une quelconque des revendications 9 et 12, **caractérisé en ce qu'**il comprend au moins deux profilés (20) s'étendant parallèlement dans la direction de l'alignement de consoles (3), reposant sur les surfaces d'appui (9) allongées et solidarisés aux sites d'ancrage ou d'accrochage (10), ces profilés (20) présentant des sites de solidarisation amovibles pour les panneaux (1) ou analogues, permettant un montage adjacent à côté de ces derniers sur lesdits profilés (20).

15. Dispositif selon l'une quelconque des revendications 8 à 14, **caractérisé en ce que** la partie supérieure (4') du corps creux (3') de chaque console (3) comporte plusieurs surfaces d'appui allongées (9), séparées entre elles par une ou des cavité(s) ou échancrure(s) transversales traversantes (16) constituées par des déformations locales de sa paroi du corps creux (3') et adaptées pour constituer chacune un palier support pour un élément allongé (17) du type conduit, canal, goulotte, chemin de câble ou analogue.

16. Dispositif selon l'une quelconque des revendications 8 à 15, **caractérisé en ce que** le corps creux (3') de chaque console (3), éventuellement formé par assemblage de deux demi-coques (3") thermoformées, est réalisé en un matériau polymère choisi dans le groupe formé par le polyéthylène haute densité (PEHD), le polycarbonate, un mélange ABS/PMMA et le polypropylène et **en ce qu'**il comporte des formations de renforcement (18, 18') en creux et en saillie au niveau de ses parois latérales, ces dernières étant divergentes en direction de la partie inférieure (4) du corps creux (3'), les deux demi-coques (3") étant, le cas échéant, assemblées par collage, soudure, enclenchement élastique ou à crans, fixation mécanique, par exemple par vis/écrous, ou analogues.

17. Dispositif selon l'une quelconque des revendications 1 à 16, **caractérisé en ce que** les corps creux (3') des consoles (3) présentent une forme évasée depuis leur partie supérieure (4') vers leur partie inférieure (4), présentant ainsi une forme tronconique en section transversale.

18. Dispositif selon l'une quelconque des revendications 2 à 16, **caractérisé en ce que** la partie inférieure (4) de chaque console (3) présente une structure ouverte en sous-face et **en ce que** le corps creux (3') correspondant comporte, en plus des formations latérales externes (6, 6'), également des formations latérales internes (22) constituant des zones d'appui au niveau des bords inférieurs des parois dudit corps creux (3').

19. Système de toiture à deux composantes intégrées comprenant une couverture étanche inférieure avec un revêtement ou une couche d'étanchéité en surface, préférentiellement une membrane d'étanchéité synthétique ou bitumineuse, et une couche supérieure composée d'éléments (1) en forme de plaques, panneaux ou analogues, notamment des panneaux photovoltaïques, située à distance de la couverture étanche inférieure,
système **caractérisé en ce que** les éléments (1) de la couche supérieure sont portés et retenus sur la couverture (2) par un dispositif de support et de fixation selon l'une quelconque des revendications 1 à 18.

20. Système de toiture selon la revendication 19, **caractérisé en ce que** la couverture étanche (2) présente en surface une membrane d'étanchéité bitumineuse, faisant éventuellement partie d'un complexe d'étanchéité à deux couches superposées, et **en ce que** les éléments (1) de la couche supérieure consistant en des panneaux photovoltaïques.

21. Console d'appui et de maintien inclinée destinée à faire partie d'un dispositif de support et de fixation d'éléments en forme de plaques selon l'une quelconque des revendications 1 à 18, essentiellement constituée d'un corps creux de forme triangulaire, avec une partie inférieure destinée à prendre appui sur la surface de la couverture et à être solidarisée à cette dernière et au moins une partie supérieure destinée à supporter directement ou indirectement un ou plusieurs éléments en forme de plaques, panneaux ou analogues, cette console présentant, vue de côté, une structure triangulaire dont la base est formée par la partie inférieure et dont le ou les côté(s) définissant avec la base un angle aigu est(sont) formé(s) par la ou les partie(s) supérieure(s) assurant le support et le maintien inclinés,
console (3) **caractérisée**
**en ce que** sa partie inférieure (4) est pourvue en sous-face d'au moins une portion (5) de plaque, de panneau, de membrane ou de feuille, formant un plastron rapporté qui est solidarisée à ladite partie inférieure (4), le ou chaque plastron (5) consistant en un matériau, ou étant à base d'un matériau compatible et/ou de même nature que la couche ou le revêtement en surface de la couverture (2) et étant lié à cette couche ou à ce revêtement par une liaison adhérente, et,
**en ce que** la partie supérieure (4') comprend une ou plusieurs portions de paroi dudit corps creux (3') fournissant une ou plusieurs surface(s) d'appui (9) allongée(s) pour les bords latéraux (1') des panneaux (1) ou analogues ou pour des profilés (20) de montage de tels panneaux.

22. Console selon la revendication 21, **caractérisé en ce que** le corps creux (3') est composé de deux demi-coques (3") complémentaires en matériau polymère ou métallique, ayant des formes symétriques, et assemblées entre elles selon un plan médian au moins au niveau des bords périphériques (13) en contact desdites demi-coques (3"), et éventuellement au niveau de formations (18) saillantes vers l'intérieur et en contact mutuel des deux demi-coques (3"), et **en ce qu'**à au moins certaines des surfaces d'appui allongées (9) de la partie supérieure (4) sont associés des sites (10) d'accrochage ou d'ancrage pour des moyens amovibles (10') de fixation latérale des panneaux (1) ou analogues sous la forme de plaques métalliques (12) allongées et percées le long d'une bande centrale (12'), ces plaques (12) comportant de part et d'autre de ladite bande centrale (12') des ailes latérales (12") s'emboîtant dans des interstices de réception (14) adaptées formés dans, à proximité ou sous les portions de paroi (9) formant la partie supérieure (4'), de telle manière que lesdites plaques métalliques allongées (12) formant inserts rigidement dans le corps creux (3') par emboîtements opposés dans les interstices (14) des deux demi-coques (3") assemblées, la bande centrale (12') perforée de chaque plaque (12) présentant les sites d'accrochage ou d'ancrage (10) étant apparente à travers une ouverture formée par coopération de découpes adaptées (15) des portions de paroi (9) des deux demi-coques (4').

23. Console selon la revendication 22 **caractérisée en ce que** chaque demi-coques (3") comporte, au niveau de la partie supérieure (4'), des déformations locales (19, 19') de la paroi latérale et des portions de paroi formant les surfaces d'appui allongée (9), qui définissent par coopération les interstices de réception (14) pour les ailes latérales (12") des plaques (12).

## Patentansprüche

1. Stütz- und Befestigungsvorrichtung für Bauteile (1) in Form von Platten, Paneelen oder dergleichen auf einer Eindeckung (2) eines Daches eines Gebäudes mit Abstand von dieser, wobei die genannte Eindeckung an der Oberfläche eine Abdichtungsschicht oder -beschichtung aufweist, die auf den im Wesentlichen durchgehenden Untergrund, der das Dach bildet, auf eine darunter liegende Abdichtungsschicht oder -beschichtung oder auf eine Wärmedämmschicht, die diesen Untergrund bedeckt, aufgetragen ist,
wobei die Vorrichtung geneigte Stütz- und Haltekonsolen (3) für die Bauteile (1) in Form von Platten, Paneelen oder dergleichen umfasst, die in mindestens einer Richtung zueinander ausgerichtet sind, wobei jede dieser Konsolen (3) einen unteren Teil (4) aufweist, dazu bestimmt, sich auf der Oberfläche der Eindeckung abzustützen und an dieser befestigt zu werden, und mindestens einen oberen Teil (4'), dazu bestimmt, direkt oder indirekt ein oder mehrere Bauteile (1) in Form von Platten, Paneelen oder dergleichen zu tragen, wobei die genannten Konsolen (3) von der Seite betrachtet eine dreieckige Struktur aufweisen, deren Basis vom unteren Teil gebildet wird und deren Seite(n), die mit der Basis einen spitzen Winkel bildet/bilden, von dem oder den oberen Teil(en) gebildet wird/werden, die das geneigte Stützen und Halten sicherstellen,
wobei jede Konsole hauptsächlich aus einem Hohlkörper besteht, einteilig oder nicht,
wobei der untere Teil (4) der genannten Konsolen (3) auf der Unterseite mit mindestens einem Teil (5) einer Platte, Tafel, Membran oder Folie versehen ist, die eine angesetzte Frontplatte bildet, die an der Konsole (3) befestigt ist, wobei die oder jede Frontplatte (5) aus einem Werkstoff besteht oder auf einem Werkstoff basiert, der mit der Schicht oder Beschichtung an der Oberfläche der Eindeckung (2) kompatibel und/oder von derselben Beschaffenheit wie sie ist und mit dieser Schicht oder Beschichtung durch eine Haftverbindung verbunden ist, Vorrichtung, **dadurch gekennzeichnet, dass** die oberen Teile (4') der Konsolen (3) einen oder mehrere Wandbereiche des genannten Hohlkörpers (3') umfassen, die eine oder mehrere lang gestreckte Anlagefläche(n) (9) für die seitlichen Ränder (1') der Paneele (1) oder dergleichen oder für Profile (20) zur Montage derartiger Paneele bieten, wobei jedes Paneel (1) oder dergleichen ausschließlich auf dem Niveau seiner einander gegenüberliegenden seitlichen Ränder, von zwei voneinander beabstandeten Konsolen (3) einer Aufreihung, gegebenenfalls durch Schienen (20), getragen werden kann.

2. Vorrichtung nach Patentanspruch 1, **dadurch gekennzeichnet, dass** der untere Teil (4) jeder Konsole (3) seitlich mindestens eine Anformung (6, 6') in der Art einer Abflachung oder dergleichen aufweist, die, gegebenenfalls jeweils, einen äußeren Auflagebereich bildet, der dazu bestimmt ist, durch Oberflächenkontakt mit der oder einer der Frontplatte(n) (5) zusammenzuwirken, und mit mehreren Öffnungen (6") für die Aufnahme von Teilen (7) zur mechanischen Befestigung versehen ist, wobei diese letzteren die entsprechende Frontplatte (5) durchqueren und jeweils mit einer eventuell gemeinsamen Platte oder einer Scheibe (8) verbunden sind, die dazu bestimmt ist, lokal die genannte Frontplatte (5) von unten an die genannte seitliche Anformung (6, 6') zu drücken.

3. Vorrichtung nach Patentanspruch 1 oder 2, **dadurch gekennzeichnet, dass** der untere Teil (4) jeder Konsole (3) einen äußeren Oberflächenkontaktbereich mindestens an jedem seiner beiden entgegengesetzten Längsenden aufweist, der sich vorzugsweise symmetrisch beiderseits der betrachteten Konsole (3) erstreckt, wobei eine Frontplatte (5) vorzugsweise mechanisch an jedem der genannten Enden unter den unteren Oberflächenkontaktbereichen der seitlichen Anlageanformungen (6, 6') des genannten unteren Teils (4) befestigt ist und eine jeweils größere Flächenausdehnung hat als die letztgenannten.

4. Vorrichtung nach irgendeinem der Patentansprüche 1 bis 3, **dadurch gekennzeichnet, dass** die Oberflächenhaftverbindung zwischen der oder jeder Frontplatte (5) und der Schicht oder Beschichtung an der Oberfläche der Eindeckung (2) eine Klebverbindung ist, wobei das Klebemittel ein zusätzlich aufgetragenes Mittel ist.

5. Vorrichtung nach irgendeinem der Patentansprüche 1 bis 3, **dadurch gekennzeichnet, dass** die Oberflächenhaftverbindung zwischen der oder jeder Frontplatte (5) und der Schicht oder Beschichtung an der Oberfläche der Eindeckung (2) eine kalt haftende Verbindung ist, wobei die Unterseite der Frontplatte (5) eine Beschichtung trägt, die über angepasste Eigenschaften verfügt.

6. Vorrichtung nach irgendeinem der Patentansprüche 1 bis 3, **dadurch gekennzeichnet, dass** die Oberflächenhaftverbindung zwischen der oder jeder Frontplatte (5) und der Schicht oder Beschichtung an der Oberfläche der Eindeckung (2) eine Schweißverbindung ist, wobei die Frontplatte (5) und die Oberflächenschicht oder -beschichtung vorzugsweise auf einer bituminösen oder synthetischen Abdichtungsmembran beruht.

7. Vorrichtung nach irgendeinem der Patentansprüche 1 bis 6, **dadurch gekennzeichnet, dass** sich die Oberflächenhaftverbindung zwischen der oder jeder Frontplatte (5) und der Schicht oder Beschichtung der Oberfläche der Eindeckung (2) im Wesentlichen über die gesamte Oberfläche der Unterseite der betrachteten Frontplatte (5) erstreckt.

8. Vorrichtung nach irgendeinem der Patentansprüche 1 bis 7, **dadurch gekennzeichnet, dass** jede Konsole (3) aus einem Hohlkörper (3') besteht, der durch Gießen oder Warmformen eines Polymer-Werkstoffes gefertigt wurde und dadurch, dass der/die Wandbereich(e) des genannten Hohlkörpers (3') des oberen Teils (4') eine oder mehrere lang gestreckte Anlagefläche(n) (9) für den seitlichen Rand (1') eines Solarzellenpaneels (1) oder dergleichen, für die seitlichen Ränder (1') mindestens zweier nebeneinander montierter Solarzellenpaneele oder für Montageprofile (20) derartiger Paneele (1) bietet oder bieten.

9. Vorrichtung nach Patentanspruch 8, **dadurch gekennzeichnet, dass** jede Konsole (3) mehrere Einhak- oder Verankerungsstellen (10) für abnehmbare Befestigungsmittel (10') zur seitlichen Befestigung der Paneele oder dergleichen (1) aufweist, die unmittelbar von der betrachteten Konsole (3) getragen werden, oder zur Befestigung eingefügter Montageprofile (20) derartiger Paneele oder dergleichen (1), wobei diese Stellen (10) über die Länge der lang gestreckten Anlageflächen (9) des oberen Teils (4) der betrachteten Konsole (3) verteilt sind.

10. Vorrichtung nach Patentanspruch 9, **dadurch gekennzeichnet, dass** jede lang gestreckte Anlagefläche (9) in der Richtung ihrer größten Länge durch Anschlagmittel (11) in zwei Einzelflächen (9') unterteilt ist, die jeweils geeignet sind, einen seitlichen Rand (1') oder einen Teil eines seitlichen Randes (1') eines Paneels oder dergleichen (1) zu tragen und dadurch, dass die Einhak- oder Verankerungsstellen (10) die Form von Durchbrüchen haben, die in einer oder mehreren Metallplatten (12) ausgebildet sind, die in den Hohlkörper (3') der betrachteten Konsole (3) integriert sind.

11. Vorrichtung nach irgendeinem der Patentansprüche 8 bis 10, **dadurch gekennzeichnet, dass** der Hohlkörper (3') aus zwei komplementären Halbschalen (3") besteht, die symmetrische Formen haben und in einer Mittelebene mindestens auf dem Niveau der Umfangsränder (13) zusammengesetzt sind, die mit den genannten Halbschalen (3") in Berührung stehen, und eventuell auf dem Niveau von Anformungen (18) der beiden Halbschalen (3"), die ins Innere ragen, miteinander in Berührung stehen.

12. Vorrichtung nach Patentanspruch 11, **dadurch gekennzeichnet, dass** mindestens mit bestimmten der lang gestreckten Anlageflächen (9) des oberen Teils (4) jeder Konsole (3) Einhak- oder Verankerungsstellen (10) für abnehmbare seitliche Befestigungsmittel (10') der Paneele (1) oder dergleichen in Form lang gestreckter und entlang eines Mittelstreifens (12') durchbrochener Metallplatten (12) verbunden sind, wobei diese Platten (12) beiderseits des genannten Mittelstreifens (12') Seitenflügel (12") aufweisen, die dazu bestimmt sind, in passende Aufnahmespalten (14) eingefügt zu werden, die in, nahe oder unter den Wandbereichen (9) ausgebildet sind, die den oberen Teil (4') der Konsole (3) bilden, derart, dass die genannten lang gestreckten Metallplatten (12) durch gegenüberliegende Einsteckverbindungen nach dem Zusammensetzen der beiden Halbschalen (3") starr im Hohlkörper (3') gehalten werden, wobei der durchbrochene Mittelstreifen (12') jeder Platte (12) Einhak- oder Verankerungsstellen (10) aufweist, die durch eine Öffnung frei bleiben, die durch Zusammenwirken passender Ausschnitte (15) der Wandbereiche (9) der beiden Halbschalen (4') gebildet wird.

13. Vorrichtung nach Patentanspruch 12, **dadurch gekennzeichnet, dass** jede Halbschale (3") in Höhe des oberen Teils (4') der betrachteten Konsole (3) lokale Verformungen (19, 19') der Seitenwand und der Wandbereiche aufweist, die die lang gestreckten Anlageflächen (9) bilden, die durch Zusammenwirken die Aufnahmespalten (14) für die Seitenflügel (12") der Platten (12) bilden.

14. Vorrichtung nach irgendeinem der Patentansprüche 9 und 12, **dadurch gekennzeichnet, dass** sie mindestens zwei Profile (20) umfasst, die sich parallel in der Ausrichtungsrichtung der Konsolen (3) erstrecken, die auf den lang gestreckten Anlageflächen (9) ruhen und die an den Einhak- oder Verankerungsstellen (10) befestigt sind, wobei diese Profile (20) Stellen zur abnehmbaren Befestigung der Paneele (1) oder dergleichen aufweisen, die eine Montage angrenzend neben diesen letzteren auf den genannten Profilen (20) erlauben.

15. Vorrichtung nach irgendeinem der Patentansprüche 8 bis 14, **dadurch gekennzeichnet, dass** der obere Teil (4') des Hohlkörpers (3') jeder Konsole (3) mehrere lang gestreckte Anlageflächen (9) aufweist, die voneinander durch eine oder mehrere durchgehende, quer verlaufende Vertiefungen oder Aussparungen (16) getrennt sind, die durch lokale Verformungen der Wand des Hohlkörpers (3') gebildet werden und die dafür ausgelegt sind, jeweils eine Tragschulter für ein lang gestrecktes Teil (17) der Art eines Rohres, Kanals, Kabelkanals oder -troges oder dergleichen zu bilden.

16. Vorrichtung nach irgendeinem der Patentansprüche 8 bis 15, **dadurch gekennzeichnet, dass** der Hohlkörper (3') jeder Konsole (3), der eventuell durch Zusammensetzen zweier warmgeformter Halbschalen (3") gebildet ist, aus einem Polymer-Werkstoff gefertigt ist, der aus der Gruppe ausgewählt ist, die besteht aus Polyethylen hoher Dichte (HDPE), Polycarbonat, einem ABS/PMMA-Gemisch und Polypropylen, und dadurch, dass er Verstärkungsanformungen (18, 18') als Vertiefungen und Vorsprünge im Bereich seiner Seitenwände aufweist, wobei diese letzteren in Richtung des unteren Teils (4) des Hohlkörpers (3') divergieren, wobei die beiden Halbschalen (3") gegebenenfalls durch Kleben, Schweißen, elastisches Einklinken oder Einrasten, mechanische Befestigung, beispielsweise durch Schrauben und Muttern, oder dergleichen zusammengesetzt sind.

17. Vorrichtung nach irgendeinem der Patentansprüche 1 bis 16, **dadurch gekennzeichnet, dass** die Hohlkörper (3') der Konsolen (3) eine sich von ihrem oberen Teil (4') zu ihrem unteren Teil (4) verbreiternde Form haben, so dass sie im Querschnitt Kegelstumpfform aufweisen.

18. Vorrichtung nach irgendeinem der Patentansprüche 2 bis 16, **dadurch gekennzeichnet, dass** der untere Teil (4) jeder Konsole (3) eine auf der Unterseite offene Struktur aufweist und dadurch, dass der entsprechende Hohlkörper (3') zusätzlich zu den äußeren seitlichen Anformungen (6, 6') auch innere seitliche Anformungen (22) aufweist, die Auflagebereiche auf dem Niveau der unteren Ränder der Wände des genannten Hohlkörpers (3') bilden.

19. Dachsystem aus zwei integrierten Bestandteilen umfassend: eine untere, abgedichtete Eindeckung mit einer Beschichtung oder einer Abdichtungsschicht an der Oberfläche, vorzugsweise mit einer synthetischen oder bituminösen Abdichtungsmembran, und eine obere Schicht aus Bauteilen (1) in Form von Platten, Paneelen oder dergleichen, insbesondere Solarzellenpaneelen, beabstandet von der unteren dichten Eindeckung, **dadurch gekennzeichnet, dass** die Bauteile (1) der oberen Schicht auf der Eindeckung (2) durch eine Stütz- und Befestigungsvorrichtung nach irgendeinem der Patentansprüche 1 bis 18 getragen und gehalten sind.

20. Dachsystem nach Patentanspruch 19, **dadurch gekennzeichnet, dass** die dichte Eindeckung (2) an der Oberfläche eine bituminöse Abdichtungsmembran aufweist, die eventuell Teil eines Abdichtungskomplexes aus zwei übereinander liegenden Schichten ist, und dadurch, dass die Bauteile (1) der oberen Schicht Solarzellenpaneele sind.

21. Konsole zum Stützen und geneigt Halten, dazu bestimmt, Teil einer Stütz- und Befestigungsvorrichtung für plattenförmige Bauteile nach irgendeinem der Patentansprüche 1 bis 18 zu sein, im Wesentlichen bestehend aus einem dreieckigen Hohlkörper mit einem unteren Teil, dazu bestimmt, auf der Oberfläche der Eindeckung zu ruhen und an dieser befestigt zu werden, und mindestens einem oberen Teil, dazu bestimmt, unmittelbar oder indirekt ein oder mehrere Bauteile in Form von Platten, Paneelen oder dergleichen zu stützen, wobei diese Konsole von der Seite betrachtet eine dreieckige Struktur aufweist, deren Basis vom unteren Teil gebildet wird und deren Seite(n), die mit der Basis einen spitzen Winkel bildet/bilden, von dem oder den oberen Teil(en) gebildet wird/werden, die das Stützen und geneigte Halten sicherstellen,
Konsole (3), **dadurch gekennzeichnet,**
**dass** ihr unterer Teil (4) auf der Unterseite mit mindestens einem Teil (5) einer Platte, Tafel, Membran oder Folie versehen ist, die eine angesetzte Frontplatte bildet, die am genannten unteren Teil (4) befestigt ist, wobei die oder jede Frontplatte (5) aus einem Werkstoff besteht oder auf einem Werkstoff basiert, der mit der Schicht oder Beschichtung an der Oberfläche der Eindeckung (2) kompatibel und/oder von derselben Beschaffenheit wie sie ist und mit dieser Schicht oder Beschichtung durch eine Haftverbindung verbunden ist, und dadurch, dass der obere Teil (4') einen oder mehrere Wandbereiche des genannten Hohlkörpers (3') umfasst, die eine oder mehrere lang gestreckte Anlagefläche(n) (9) für die seitlichen Ränder (1') der Paneele (1) oder dergleichen oder für Profile (20) zur Montage derartiger Paneele bieten.

22. Konsole nach Patentanspruch 21, **dadurch gekennzeichnet, dass** der Hohlkörper (3') aus zwei komplementären Halbschalen (3") aus metallischem oder Polymer-Werkstoff besteht, die symmetrische Formen haben und mindestens auf dem Niveau der Umfangsränder (13), die mit den genannten Halbschalen (3") in Berührung stehen, und eventuell auf dem Niveau von Anformungen (18), die ins Innere ragen und mit den beiden Halbschalen (3") in Berührung stehen, entlang einer Mittelebene zusammengesetzt sind, und dadurch, dass mindestens mit bestimmten der lang gestreckten Anlageflächen (9) des oberen Teils (4) Einhak- oder Verankerungsstellen (10) für abnehmbare seitliche Befestigungsmittel (10') der Paneele (1) oder dergleichen in Form lang gestreckter und entlang eines Mittelstreifens (12') durchbrochener Metallplatten (12) verbunden sind, wobei diese Platten (12) beiderseits des genannten Mittelstreifens (12') Seitenflügel (12") aufweisen, die in passende Aufnahmespalten (14) eingesteckt werden, die in, nahe oder unter den Wandbereichen (9) ausgebildet sind, die den oberen Teil (4') bilden, derart, dass die genannten lang gestreckten Metallplatten (12) durch Einstecken in die gegenüberliegenden Spalten (14) der beiden zusammengesetzten Halbschalen (3") starre Einsätze im Hohlkörper (3') bilden, wobei der durchbrochene Mittelstreifen (12') jeder Platte (12) die Einhak- oder Verankerungsstellen (10) aufweist, die durch eine Öffnung frei bleiben, die durch Zusammenwirken passender Ausschnitte (15) der Wandbereiche (9) der beiden Halbschalen (4') gebildet ist.

23. Konsole nach Patentanspruch 22, **dadurch gekennzeichnet, dass** jede Halbschale (3") in Höhe des oberen Teils (4') lokale Verformungen (19, 19') der Seitenwand und der Wandbereiche, die die lang gestreckten Anlageflächen (9) bilden, aufweist, die durch Zusammenwirken die Aufnahmespalten (14) für die Seitenflügel (12") der Platten (12) bilden.

## Claims

1. Device for support and attachment of elements (1) in the form of plates, panels or the like on a building roof cover (2), at some distance from the latter, with said cover comprising on the surface a covering or a sealing layer connected to the essentially continuous support forming the roof, to an underlying layer or sealing covering, or to a thermal insulation layer covering this support,
the device comprising inclined support and holding brackets (3) for the elements (1) in the form of plates, panels or the like, arranged according to at least one alignment, each of these brackets (3) having a lower portion (4) designed to rest on the surface of the cover and to be secured to the latter, and at least one upper portion (4') designed to support directly or indirectly one or more elements (1) in the form of plates, panels or the like, said brackets (3) having, seen from the side, a triangular structure whose base is formed by the lower portion and whose side(s) defining with the base an acute angle is (are) formed by the upper portion(s) ensuring the inclined support and holding,
each bracket consisting primarily of a hollow body, which may or may not consist of a single piece,
the lower portion (4) of said brackets (3) being provided on the underside with at least one portion (5) of plate, panel, membrane or sheet, forming a connected protector that is secured to the bracket (3), with the protector or each protector (5) consisting of a material or being based on a material that is compatible with and/or of the same nature as the layer or the covering on the surface of the cover (2) and being connected to this layer or to this covering by an adhesive connection,
device **characterised in that** the upper portions (4') of the brackets (3) comprise one or more portions of wall of said hollow body (3') providing one or more elongated support surface(s) (9) for the lateral edges (1') of the panels (1) or the like or for profile members (20) for mounting such panels, each panel (1) or the like being possibly supported only at its opposite lateral edges, optionally by means of rails (20), by two brackets (3) that are separated from one another by an alignment.

2. Device according to claim 1, **characterised in that** the lower portion (4) of each bracket (3) has at least one lateral formation (6, 6') of the flat-surface type or the like, providing, each if necessary, an external support area, designed to work by surface contact with the protector or one of the protector(s) (5) and provided with several openings (6") for accommodating mechanical attachment elements (7), with the latter passing through the corresponding protector (5) and each being combined with a small plate, optionally a common small plate, or with a washer (8) that is designed to press locally said protector (5) against said lateral formation (6, 6') from below.

3. Device according to claim 1 or 2, **characterised in that** the lower portion (4) of each bracket (3) has an external surface support area at least at each of its opposite longitudinal ends, preferably extending symmetrically from each side of the bracket (3) being considered, a protector (5) being attached, preferably mechanically, at each of said ends, under the lower surface support areas of lateral support formations (6, 6') of said lower portion (4) and with a surface extension that is respectively larger than the latter.

4. Device according to any of claims 1 to 3, **characterised in that** the surface adhesive connection between the protector or each protector (5) and the layer or the surface covering of the cover (2) is a connection by gluing, with the gluing agent being a connected additional agent.

5. Device according to any of claims 1 to 3, **characterised in that** the surface adhesive connection between the protector or each protector (5) and the layer or the surface covering of the cover (2) is a cold adhesion connection, with the underside of the protector (5) comprising a covering having suitable properties.

6. Device according to any of claims 1 to 3, **characterised in that** the surface adhesive connection between the protector or each protector (5) and the layer or the surface covering of the cover (2) is a connection by welding, with the protector (5) and the layer or surface covering preferably being based on a bituminous or synthetic sealing membrane.

7. Device according to any of claims 1 to 6, **characterised in that** the surface adhesive connection between the protector or each protector (5) and the layer or the surface covering of the cover (2) extends essentially over the entire surface of the underside of the protector (5) being considered.

8. Device according to any of claims 1 to 7, **characterised in that** each bracket (3) consists of a hollow body (3') that is obtained by molding or thermoforming a polymer material and **in that** the wall portion(s) of said hollow body (3') of the upper portion (4') provide(s) one or more elongated support surface(s) (9) for the lateral edge (1') of a photovoltaic panel (1) or the like, for the lateral edges (1') of at least two photovoltaic panels mounted side-by-side or for profile members (20) for mounting such panels (1).

9. Device according to claim 8, **characterised in that** each bracket (3) comprises a large number of hooking or anchoring sites (10) for removable engagement means (10') for a lateral attachment of panels or the like (1) that are directly supported by the bracket (3) being considered or for an attachment of intermediate profile members (20) for mounting such panels or the like (1), with these sites (10) being distributed along elongated support surfaces (9) of the upper portion (4) of the bracket (3) being considered.

10. Device according to claim 9, **characterised in that** each elongated support surface (9) is subdivided, in the direction of its greatest length, by stop means (11) into two elementary surfaces (9'), each capable of supporting a lateral edge (1') or a portion of a lateral edge (1') of a panel or the like (1), and **in that** the hooking or anchoring sites (10) come in the form of perforations made in one or more metal plates (12) that are integrated into the hollow body (3') of the bracket (3) in question.

11. Device according to any of claims 8 to 10, **characterised in that** the hollow body (3') consists of two complementary half-shells (3"), having symmetrical shapes, and assembled with one another along a median plane at least at peripheral edges (13) in contact with said half-shells (3"), and optionally at formations (18), projecting towards the inside and in mutual contact, of the two half-shells (3").

12. Device according to claim 11, **characterised in that** hooking or anchoring sites (10) for removable means (10') of lateral attachment of panels (1) or the like in the form of metal plates (12) that are elongated and pierced along a central strip (12') are combined with at least some of the elongated support surfaces (9) of the upper portion (4) of each bracket (3), whereby these plates (12), on both sides of said central strip (12'), comprise lateral wings (12") that are designed to be embedded in suitable receiving gaps (14) that are formed in, close to, or under the wall portions (9) forming the upper portion (4') of the bracket (3) in such a way that said elongated metal plates (12) are held rigidly in the hollow body (3') by opposite interlocking after assembly of the two half-shells (3"), the perforated central strip (12') of each plate (12) having hooking or anchoring sites (10), with said strip being visible through an opening formed by cooperation of suitable cutouts (15) of wall portions (9) of two half-shells (4').

13. Device according to claim 12, **characterised in that** each half-shell (3") comprises, at the upper portion (4') of the bracket (3) being considered, local deformations (19, 19') of the side wall and wall portions forming the elongated support surfaces (9), which define by cooperation the receiving gaps (14) for the lateral wings (12") of the plates (12).

14. Device according to any of claims 9 and 12, **characterised in that** it comprises at least two profile members (20) extending parallel in the direction of the alignment of brackets (3), resting on the support surfaces (9) that are elongated and secured to the anchoring or hooking sites (10), with these profile members (20) having removable engagement sites for the panels (1) or the like, making possible an adjacent mounting beside the latter on said profile members (20).

15. Device according to any of claims 8 to 14, **characterised in that** the upper portion (4') of the hollow body (3') of each bracket (3) comprises multiple elongated support surfaces (9), separated from one another by one or more through transverse cavity(ies) or cutout(s) (16) that consist of local deformations of its wall of the hollow body (3') and each adapted to constitute a support bearing for an elongated element (17) such as a pipe, channel, funnel, cable path, or the like.

16. Device according to any of claims 8 to 15, **characterised in that** the hollow body (3') of each bracket (3), optionally formed by assembly of two thermoformed half-shells (3"), is made of a polymer material that is selected from the group that is formed by high-density polyethylene (HDPE), polycarbonate, an ABS/PMMA mixture, and polypropylene, and **in that** it comprises hollow and projecting reinforcement formations (18, 18') at its side walls, the latter being divergent in the direction of the lower portion (4) of the hollow body (3'), with the two half-shells (3") being, if necessary, assembled by gluing, welding, elastic interlocking or catch interlocking, mechanical attachment, for example by screws/nuts, or the like.

17. Device according to any of claims 1 to 16, **characterised in that** the hollow bodies (3') of the brackets (3) have a tapered shape from their upper portion (4') to their lower portion (4), thus having a truncated shape in cross-section.

18. Device according to any of claims 2 to 16, **characterised in that** the lower portion (4) of each bracket (3) has an open structure on the underside and **in that** the corresponding hollow body (3') comprises, in addition to the outside lateral formations (6, 6'), also inside lateral formations (22) constituting support areas at lower edges of the walls of said hollow body (3').

19. Roofing system with two integrated components comprising a lower airtight cover with a covering or a surface sealing layer, preferably a synthetic or bituminous sealing membrane, and an upper layer composed of elements (1) in the form of plates, panels or the like, in particular photovoltaic panels, located at some distance from the lower airtight cover,
system **characterised in that** the elements (1) of the upper layer are carried and held on the cover (2) by a support and attachment device according to any of claims 1 to 18.

20. Roofing system according to claim 19, **characterised in that** the airtight cover (2) has on the surface a bituminous sealing membrane, optionally forming part of a sealing complex with two superposed layers, and **in that** the elements (1) of the upper layer consist of photovoltaic panels.

21. Inclined support and holding bracket that is designed to be part of a device for support and attachment of elements in the form of plates according to any of claims 1 to 18, essentially consisting of a hollow body of triangular shape, with a lower portion that is designed to rest on the surface of the cover and to be secured to the latter and at least one upper portion that is designed to support directly or indirectly one or more elements in the form of plates, panels or the like, with this bracket having, seen from the side, a triangular structure whose base is formed by the lower portion and of which the side(s) defining an acute angle with the base is (are) formed by the upper portion(s) ensuring the inclined support and holding,
bracket (3) **characterised**
**in that** its lower portion (4) is provided on the underside with at least one portion (5) of plate, panel, membrane or sheet, forming a connected protector that is secured to said lower portion (4), with the protector or each protector (5) consisting of a material or being based on a material that is compatible with and/or of the same nature as the layer or the surface covering of the cover (2) and being connected to this layer or to this covering by an adhesive connection, and
**in that** the upper portion (4') comprises one or more portions of wall of said hollow body (3') providing one or more elongated support surface(s) (9) for the lateral edges (1') of the panels (1) or the like or for profile members (20) for mounting such panels.

22. Bracket according to claim 21, **characterised in that** the hollow body (3') consists of two complementary half-shells (3") made of polymer or metal material, having symmetrical shapes, and assembled with one another along a median plane at least at the peripheral edges (13) in contact with said half-shells (3") and optionally at the formations (18) projecting towards the inside and in mutual contact with the two half-shells (3"), and **in that** hooking or anchoring sites (10) for removable means (10') for lateral attachment of panels (1) or the like in the form of metal plates (12) that are elongated and pierced along a central strip (12') are combined with at least some of the elongated support surfaces (9) of the upper portion (4), with these plates (12) comprising, on both sides of said central strip (12'), lateral wings (12") that are embedded in suitable receiving gaps (14) that are formed in, close to or under the wall portions (9) that form the upper portion (4'), in such a way that said elongated metal plates (12) form inserts rigidly in the hollow body (3') by opposite interlocking in the gaps (14) of the two assembled half-shells (3"), with the central perforated strip (12') of each plate (12) having hooking or anchoring sites (10), with said strip being visible through an opening formed by cooperation of suitable cutouts (15) of wall portions (9) of two half-shells (4').

23. Bracket according to claim 22, **characterised in that** each half-shell (3") comprises, at the upper portion (4'), local deformations (19, 19') of the side wall and wall portions forming the elongated support surfaces (9), which define by cooperation the receiving gaps (14) for the lateral wings (12") of the plates (12).
